(19) Europäisches Patentamt / European Patent Office / Office européen des brevets

(11) **EP 3 332 478 B1**

(12) **EUROPÄISCHE PATENTSCHRIFT**

(45) Veröffentlichungstag und Bekanntmachung des Hinweises auf die Patenterteilung:
**23.08.2023 Patentblatt 2023/34**

(21) Anmeldenummer: **16753855.2**

(22) Anmeldetag: **01.08.2016**

(51) Internationale Patentklassifikation (IPC):
**H03H 17/02** *(2006.01)*

(52) Gemeinsame Patentklassifikation (CPC):
**H03H 17/0213; H03H 2017/0214**

(86) Internationale Anmeldenummer:
**PCT/EP2016/068310**

(87) Internationale Veröffentlichungsnummer:
**WO 2017/021357 (09.02.2017 Gazette 2017/06)**

(54) **VORRICHTUNG ZUM VERÄNDERN EINER ABTASTRATE, SYSTEM UMFASSEND EINE VORRICHTUNG ZUM VERÄNDERN EINER ABTASTRATE UND VERFAHREN ZUM VERÄNDERN EINER ABTASTRATE**

DEVICE FOR CHANGING A SAMPLING RATE, SYSTEM COMPRISING A DEVICE FOR CHANGING A SAMPLING RATE AND METHOD FOR CHANGING A SAMPLING RATE

DISPOSITIF POUR MODIFIER UNE FRÉQUENCE D'ÉCHANTILLONNAGE, SYSTÈME COMPRENANT UN DISPOSITIF POUR MODIFIER UNE FRÉQUENCE D'ÉCHANTILLONNAGE ET PROCÉDÉ POUR MODIFIER UNE FRÉQUENCE D'ÉCHANTILLONNAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.08.2015 DE 102015214950**

(43) Veröffentlichungstag der Anmeldung:
**13.06.2018 Patentblatt 2018/24**

(73) Patentinhaber: **Innovationszentrum für Telekommunikationstechnik GmbH IZT 91058 Erlangen (DE)**

(72) Erfinder: **PERTHOLD, Rainer 91085 Weisendorf (DE)**

(74) Vertreter: **Schenk, Markus et al Schoppe, Zimmermann, Stöckeler Zinkler, Schenk & Partner mbB Patentanwälte Radlkoferstrasse 2 81373 München (DE)**

(56) Entgegenhaltungen:
**EP-A2- 1 032 126 WO-A2-2008/031504**

JP-A- H0 846 555 US-A1- 2013 287 226

- A Tkacenko: "Variable Sample Rate Conversion Techniques for the Advanced Receiver", , 15 February 2007 (2007-02-15), XP055748845, Retrieved from the Internet: URL:https://ipnpr.jpl.nasa.gov/progress_report/42-168/168A.pdf [retrieved on 2020-11-09]
- Francis P. Russell ET AL: "Optimised three-dimensional Fourier interpolation: An analysis of techniques and application to a linear-scaling density functional theory code", COMPUTER PHYSICS COMMUNICATION., vol. 187, 1 February 2015 (2015-02-01), pages 8-19, XP055748849, NL ISSN: 0010-4655, DOI: 10.1016/j.cpc.2014.09.019
- LYONS R: "How to interpolate in the Time-Domain by Zero-Padding in the Frequency Domain", INTERNET CITATION, 13 January 2001 (2001-01-13), XP002281208, Retrieved from the Internet: URL:http://www.dspguru.com/howto/tech/zeropad.htm [retrieved on 2004-05-21]

## Beschreibung

Die vorliegende Erfindung bezieht sich auf eine Vorrichtung zum Verändern einer Abtastrate, auf ein System, das eine Vorrichtung zum Verändern einer Abtastrate umfasst, auf ein Verfahren zum Verändern einer Abtastrate und auf ein Computerprogramm.

Anwendungen im Bereich der Signalverarbeitung und/oder der Datenverarbeitung erfordern eine Dezimation eines digitalisierten Signals. Als Dezimation wird eine Reduzierung der Bandbreite eines digitalisierten Signals bei gleichzeitiger Reduzierung der Abtastrate des digitalisierten Signals verstanden.

Eine Dezimation kann beispielsweise mittels eines Polyphasenfilters erhalten werden. Ein Polyphasenfilter stellt ein gängiges Verfahren zur Dezimation mit variabler Abtastrate rein im Zeitbereich dar. Dabei wird die Impulsantwort des Dezimationsfilters stark überabgetastet, etwa mit einem Faktor von n = 1024, gespeichert. Je nach Ausgangstakt wird die Schiebekette des verwendeten FIR-Filters (FIR = Finite Impulse Response, endliche Impulsantwort) um n Schritte weitergeschoben. Gleichzeitig werden die Eingangsdaten mit dem der gewünschten Dezimationsrate entsprechenden Abstand m in die Schiebekette gelegt und mit dem entsprechenden Koeffizienten des FIR-Filters gewichtet. Im Regelfall ist m nicht ganzzahlig und es wird mittels "nearest neighbor" (nearest neighbor = nächster Nachbar) der passende Koeffizient gewählt.

Alternativ wird linear zwischen zwei Koeffizienten interpoliert. Das Verfahren hat jedoch Nachteile. Bei hohen relativen Bandbreiten werden entsprechend lange Filter erforderlich, was den Bedarf an Rechenzeit überproportional erhöht. Ohne eine lineare Interpolation zwischen Koeffizienten muss der Faktor n groß gewählt werden, etwa im Bereich 10000, um eine gute Signalqualität zu erreichen. Das führt zu einem hohen Speicherbedarf. Wird hingegen eine lineare Interpolation verwendet, kann eine geringere Anzahl von Koeffizienten verwendet werden. Im Gegenzug werden jedoch die Berechnungen komplexer. Ferner erschwert die komplexe Struktur des Gedächtnisses des Filters eine parallele/verteilte Verarbeitung der Daten in mehreren Prozessorkernen.

Ein sogenannter "Farrow-Interpolator" stellt eine Kombination aus einem kurzen FIR-Filter und einer Polynominterpolation dar. Nachteilig sind ein schlechter SFDR (spurious free dynamic range - störungsfreier Bereich) im Bereich von in etwa 50 dB sowie die Notwendigkeit, vor dem eigentlichen Interpolator die Bandbreite des Signals begrenzen zu müssen. Dies führt zu zusätzlichem Rechenaufwand. Für Anwendungen in der Messtechnik und der Funkerfassung ist der Farrow-Interpolator daher in der Regel nicht einsetzbar. Eine reine Polynominterpolation der Eingangsdaten zur Bestimmung der Ausgangsdaten an den erforderlichen Zeitpunkten leidet an den gleichen Nachteilen wie der Farrow-Interpolator und ist ebenfalls nicht einsetzbar.

A Tkacenko: "Variable Sample Rate Conversion Techniques for the Advanced Receiver", XP055748845, offenbart am 15. Februar 2007, und gefunden im Internet: URL:https:// ipnpr.jpl.nasa.gov/progress_report/42-168/168A.pdf am 09. 11. 2020, offenbart ein ähnliches Konzept einer zweistufigen Interpolation im Zeitbereich mittels einer groben Interpolation als FIR Filterung und nachfolgender feiner Polynominterpolation.

Eine Dezimation im Frequenzbereich mittels schneller Faltung kann im Frequenzbereich durchgeführt werden, wenn eingangs- und ausgangsseitig unterschiedliche Längen für eine schnelle Fourier-Transformation (fast Fourier transformation - FFT) mit einer Transformationslänge N1 - FFT(N1) und eine inverse FFT mit der Transformationslänge N2 - IFFT(N2) mit N1 > N2 verwendet werden und die Filtercharakteristik so gewählt wurde, dass nach Anwendung des Fensters maximal N2 Frequenzbins (Frequenzbin = Frequenzlinie des Spektrums) betrachtet werden müssen. Die Abtastrate am Eingang verhält sich zur Abtastrate am Ausgang wie N1/N2. Nachteilig an diesem Verfahren ist, dass N1 und N2 mindestens ganzzahlig sein müssen, um eine Realisierung über eine diskrete Fourier-Transformation (DFT) zu ermöglichen, was sehr ineffizient und nicht praxisrelevant ist. Ein weiterer Nachteil besteht darin, dass in der Regel nur für Zweierpotenzen von N1 und N2 relevante Implementierungen für Mikroprozessoren, etwa für eine Cooley-Tukey Transformation, verfügbar sind. Auch Primfaktor-FFTs sind deutlich weniger effizient, nur für bestimmte Verhältnisse zwischen N1/N2 verfügbar und im Regelfall nicht in Programm-Bibliotheken enthalten.

Somit besteht ein Bedarf an effizienten und flexiblen Algorithmen zur Dezimation von Abtastraten.

Eine Aufgabe der vorliegenden Erfindung besteht darin, ein Konzept zu schaffen, das es ermöglicht, ein Informationssignal mit einer ersten Abtastrate effizient und/oder mit einer hohen Flexibilität in ein Informationssignal mit einer anderen, geringeren oder höheren Abtastrate zu überführen.

Diese Aufgabe wird durch den Gegenstand der unabhängigen Patentansprüche gelöst. Erfindungsgemäße Weiterbildungen sind in den Unteransprüchen definiert.

Ein Kerngedanke der vorliegenden Erfindung besteht darin, erkannt zu haben, dass eine Dezimation basierend auf zwei Veränderungen der Abtastrate erhalten werden kann. Eine erste, grob vorveränderte Abtastrate kann basierend auf einer ersten Veränderung mit einem effizienten Verhältnis erhalten werden. Basierend auf einer zweiten Veränderung der Abtastrate unter Verwendung einer Interpolation kann die erhaltene vorveränderte Abtastrate angepasst, d. h., verändert werden. Die Interpolation ist bzgl. des Grades der Veränderung der Abtastrate flexibel ausgestaltet ist, wobei das Gesamtkonzept insgesamt effizient bleibt. Somit kann eine flexible Abtastrate effizient erhalten werden.

Gemäß einem Ausführungsbeispiel umfasst eine Vorrichtung zum Verändern einer Abtastrate einen Vorwärtstransformator zum Bilden einer ersten Version eines Spektrogramms mittels einer Transformation mit einer ersten Transformationslänge aus einem Informationssignal, das eine erste Abtastrate aufweist. Die Vorrichtung umfasst einen Prozessor zum Bilden einer zweiten Version des Spektrogramms, das gegenüber der ersten Version eine geringere Bandbreite aufweist. Die Vorrichtung umfasst einen Rückwärtstransformator zum Bilden eines grob vorveränderten Informationssignals mittels einer Rücktransformation der zweiten Version des Spektrogramms mit einer zweiten Transformationslänge, die gegenüber der ersten Transformationslänge verringert ist. Die zweite Abtastrate ist gegenüber der ersten Abtastrate verringert. Die Vorrichtung umfasst ferner einen Zeitbereichsinterpolator zum Erhalten eines Informationssignals mit einer dritten Abtastrate, die gegenüber der zweiten Abtastrate verändert ist. Der Zeitbereichsinterpolator ist ausgebildet, um das Informationssignal mit der dritten Abtastrate mittels Interpolation des vorveränderten Informationssignals zu erhalten. Vorteilhaft an diesem Ausführungsbeispiel ist, dass die zweite Abtastrate mittels des Zeitbereichsinterpolators angepasst werden kann. Die zweite Version des Spektrogramms ist mit einer Anzahl von Frequenzlinien darstellbar. Der Prozessor ist ausgebildet, um der ersten Anzahl von Frequenzlinien eine zweite Anzahl von Frequenzlinien mit einem vordefinierten Wert hinzuzufügen. Eine Summe der ersten Anzahl und der zweiten Anzahl entspricht der kleinsten Potenz der Zahl 2 mit einer natürlichen Zahl, wobei die Potenz größer als oder gleich der ersten Anzahl ist. Vorteilhaft daran ist, dass die erste Anzahl von Frequenzlinien auf eine nicht größere Zweierpotenz von Frequenzlinien aufgerundet werden kann, um ein effizientes Bilden des grob vorveränderten Informationssignals mittels inverser Fourier-Transformation zu ermöglichen. Alternativ oder zusätzlich ist der Prozessor ausgebildet ein erstes Frequenzfenster auf die erste Version des Spektrogramms anzuwenden und um die zweite Version des Spektrogramms basierend auf Frequenzanteilen, für die das erste Frequenzfenster einen Funktionsbetragswert aufweist, der größer als ein Schwellwert ist, zu erhalten.

Gemäß einem weiteren Ausführungsbeispiel ist der Zeitbereichsinterpolator ausgebildet, um Abtastwerte der dritten Abtastrate mittels einer Polynominterpolation zu erhalten, wobei die Polynominterpolation auf Abtastwerten der zweiten Abtastrate basiert. Vorteilhaft an diesem Ausführungsbeispiel ist, dass die Polynominterpolation basierend auf der bandbegrenzten zweiten Version des Spektrogramms mit einem geringen Rechenaufwand erfolgen kann. Abtastwerte der dritten Abtastrate können mit einer hohen Genauigkeit erhalten werden. Die Polynominterpolation kann somit mit geringem Rechenaufwand und mit geringen Signalabweichungen erhalten werden.

Gemäß einem weiteren Ausführungsbeispiel ist der Prozessor ausgebildet, um ein Frequenzfenster, bspw. ein FIR-Filter, auf die erste Version des Spektrogramms anzuwenden und um die zweite Version des Spektrogramms basierend auf Frequenzanteilen, für die das erste Frequenzfenster einen Funktionsbetragswert aufweist, der größer ist als ein Schwellwert, zu erhalten. Vorteilhaft an diesem Ausführungsbeispiel ist, dass ein Frequenzbereich des Frequenzfensters flexibel einstellbar ist, so dass die zweite Version mit einer flexiblen Bandbreite erhalten werden kann.

Weitere Ausführungsbeispiele schaffen eine Vorrichtung, bei der der Prozessor ausgebildet ist, um der ersten Anzahl von Frequenzlinien eine dritte Anzahl von Frequenzlinien mit dem vordefinierten Wert hinzuzufügen. Die dritte Anzahl entspricht der einfachen oder dreifachen Anzahl der ersten oder zweiten Anzahl, so dass insgesamt eine doppelte oder vierfache Anzahl von Frequenzlinien erhalten wird. Dies ermöglicht eine Interpolation der Frequenzlinien, so dass ein Rechenaufwand des Zeitbereichsinterpolators gering sein kann, da eine hohe Anzahl von Frequenzlinien und damit eine hohe Anzahl von Abtastwerten im Zeitbereich einen vordefinierten Wert aufweist.

Gemäß weiterer Ausführungsbeispiele ist der Prozessor ausgebildet, um ein erstes und zumindest ein zweites Frequenzfenster auf die erste Version des Spektrogramms anzuwenden und um die zweite Version des Spektrogramms basierend auf Frequenzanteilen zu erhalten, für die das erste und das zumindest zweite Frequenzfenster einen Funktionsbetragswert aufweisen, der größer als der Schwellwert ist. Das erste Frequenzfenster und das zumindest zweite Frequenzfenster weisen eine zueinander verschobene Gruppenlaufzeit auf. Vorteilhaft an diesem Ausführungsbeispiel ist, dass alternativ oder zusätzlich zu einer Interpolation der Frequenzlinien durch vordefinierte Werte eine erhöhte Anzahl von Frequenzlinien der zweiten Version durch eine Anwendung mehrerer Frequenzfenster erhalten werden kann.

Gemäß einem weiteren Ausführungsbeispiel umfasst eine Vorrichtung ferner einen Signaleingang, der ausgebildet ist, um ein Eingangssignal zu empfangen, das eine Vorgabe bezüglich einer Abtastrate aufweist. Die Vorrichtung umfasst ferner ein Steuerelement, das ausgebildet ist, den Vorwärtstransformator zu steuern, so dass eine Länge der ersten Transformationslänge verändert wird, oder um den Prozessor zu steuern, so dass eine Länge der zweiten Transformationslänge verändert wird. Vorteilhaft an diesem Ausführungsbeispiel ist, dass basierend auf einer veränderten Länge der ersten Transformationslänge oder der zweiten Transformationslänge ein Verhältnis zwischen der ersten und der zweiten Transformationslänge bzw. eine Dezimationsrate der Vorrichtung einstellbar ist.

Gemäß einem weiteren Ausführungsbeispiel bezieht sich die Vorgabe des Eingangssignals auf die dritte Abtastrate. Das Steuerelement ist ausgebildet, um die dritte Abtastrate, etwa die Feinjustierung des Zeitbereichsinterpolators einzustellen. Vorteilhaft daran ist, dass eine hohe Anzahl von Dezimationsraten, d.h. einem Verhältnis zwischen der dritten Abtastrate und der ersten Abtastrate, einstellbar sind. Gemäß Ausführungsbeispielen ist die Dezimationsrate beliebig einstellbar.

Gemäß einem weiteren Ausführungsbeispiel umfasst ein Verfahren zum Verändern einer Abtastrate ein Bilden einer ersten Version eines Spektrogramms mittels einer Transformation mit einer ersten Transformationslänge aus einem Informationssignal, das eine erste Abtastrate aufweist. Das Verfahren umfasst ein Bilden einer zweiten Version des Spektrogramms, das gegenüber der ersten Version eine geringere Bandbreite aufweist und ein Bilden eines grob vorveränderten Informationssignals mit einer zweiten Abtastrate, die gegenüber der ersten Abtastrate verringert ist, mittels einer Rücktransformation der zweiten Version mit einer zweiten Transformationslänge, die gegenüber der ersten Transformationslänge verringert ist. Das Verfahren umfasst ferner ein Erhalten eines Informationssignals mit einer dritten Abtastrate, die gegenüber der zweiten Abtastrate verändert ist, mittels Interpolation des vorveränderten Informationssignals.

Weitere Ausführungsbeispiele beziehen sich auf ein System mit einer Vorrichtung zum Verändern einer Abtastrate und auf ein Computerprogramm.

Bevorzugte Ausführungsbeispiele der vorliegenden Erfindung werden nachfolgend Bezug nehmend auf die beiliegenden Zeichnungen erläutert. Es zeigen:

Fig. 1    ein schematisches Blockschaltbild einer Vorrichtung zum Verändern einer Abtastrate gemäß einem Ausführungsbeispiel;

Fig. 2    ein schematisches Blockschaltbild einer Vorrichtung zum Verändern einer Abtastrate, die ein Steuerelement aufweist, gemäß einem Ausführungsbeispiel;

Fig. 3    eine schematisches Flussdiagramm eines Verfahrens zum Verändern einer Abtastrate gemäß einem Ausführungsbeispiel;

Fig. 4a    einen schematischen Verlauf eines Informationssignals im Zeitbereich gemäß einem Ausführungsbeispiel;

Fig. 4b    eine schematische Darstellung einer ersten Version eines Spektrogramms des Informationssignals aus Fig. 4a gemäß einem Ausführungsbeispiel;

Fig. 4c    eine schematische Darstellung einer Anwendung eines Frequenzfensters auf die erste Version gemäß einem Ausführungsbeispiel;

Fig. 4d    eine schematische Darstellung eines Weglassens von Frequenzbins, für die ein Betragswert des Frequenzfensters einen Schwellwert unterscheidet, gemäß einem Ausführungsbeispiel;

Fig. 4e    eine schematische Darstellung eines Hinzufügens von vordefinierten Werten zu den Frequenzbins, um eine zweite Version des Spektrogramms zu erhalten gemäß einem Ausführungsbeispiel;

Fig. 4f    eine schematische Darstellung eines Verlauf eines vordefinierten Informationssignals im Zeitbereich;

Fig. 5a    eine schematische Darstellung einer Anwendung eines ersten Frequenzfensters und eines zweiten Frequenzfenster auf die Frequenzbins der ersten Version gemäß einem Ausführungsbeispiel;

Fig. 5b    eine schematische Darstellung eines Weglassen von Frequenzbins, für die ein Wert der Multiplikation der Frequenzbins mit den Frequenzfenstern oder der Betragswert des Frequenzfensters den Schwellwert unterschreitet, gemäß einem Ausführungsbeispiel;

Fig. 5c    eine schematische Darstellung eines Hinzufügens der vordefinierten Werte gemäß Fig. 4e gemäß einem Ausführungsbeispiel; und

Fig. 6    ein schematisches Blockschaltbild eines Systems, das die Vorrichtung aufweist, gemäß einem Ausführungsbeispiel.

Manche der nachfolgend beschriebenen Ausführungsbeispiele beziehen sich auf ein Erhalten einer ersten Version eines Spektrogramms aus einem Informationssignal, das eine erste Abtastrate aufweist. Ausführungsbeispiele werden so beschrieben, dass basierend auf der ersten Version eine zweite Version eines Spektrogramms erhalten wird. Die zweite Version wird nachfolgend so beschrieben, dass eine Bandbreite der zweiten Version verglichen mit der ersten Version verringert ist. Ferner beziehen sich nachfolgend beschriebene Ausführungsbeispiele darauf, dass basierend auf der zweiten Version des Spektrogramms ein Informationssignal mit einer zweiten Abtastrate erhalten wird, wobei die zweite Abtastrate gegenüber der ersten Abtastrate verringert ist. Gemäß anderen Ausführungsbeispielen kann die zweite Abtastrate gegenüber der ersten Abtastrate erhöht sein.

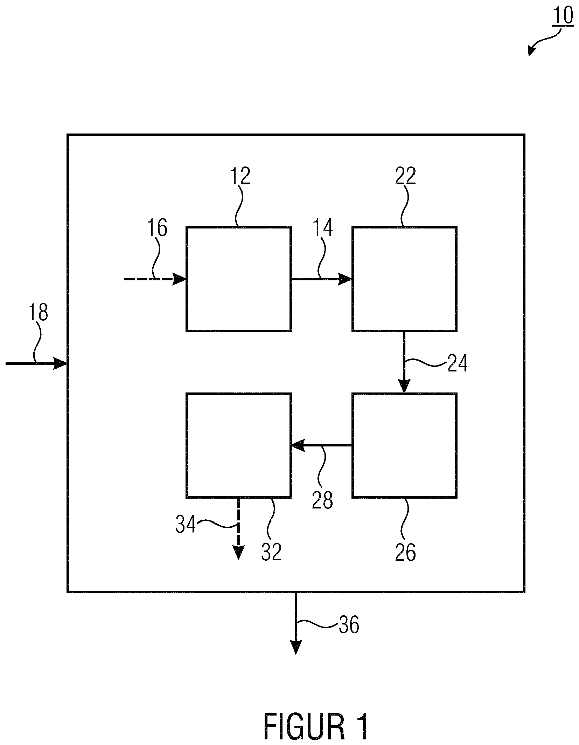

Fig. 1 zeigt ein schematisches Blockschaltbild einer Vorrichtung 10 zum Verändern einer Abtastrate. Die Vorrichtung 10 umfasst einen Vorwärtstransformator 12. Der Vorwärtstransformator 12 ist ausgebildet, um eine erste Version 14 eines Spektrogramms basierend auf einer Transformation eines Informationssignals 16 zu bilden. Das Informationssignal 16 kann ein von der Vorrichtung 10 empfangenes Signal 18 sein. Bei dem Signal 18 kann es sich beispielsweise um ein Kommunikations- und/oder Messsignal handeln. Das Informationssignal 16 kann das Signal 18 sein oder darauf basieren. Beispielsweise kann das Signal 18 vorverarbeitet werden, etwa gefiltert oder vorverstärkt. Insbesondere kann es sich bei dem Informationssignal 16 um ein Hochfrequenzsignal handeln, das bedeutet, eine Frequenz des Signals kann zumindest 100 kHz, zumindest 1 MHz oder zumindest 10 MHz betragen. Das Informationssignal 16 weist eine erste Abtastrate auf. Der Vorwärtstransformator 12 ist ausgebildet, um die erste Version 14 mit einer Transformation, die eine erste Transformationslänge aufweist, zu bilden.

Das Informationssignal kann überabgetastet empfangen werden. Für eine weitere Verarbeitung kann eine Reduzierung des Grades der Überabtastung wünschenswert sein, so dass ein Signal mit einer reduzierten Abtastrate gewünscht ist. Bspw. kann das Informationssignal eine beliebige Abtastrate, etwa in einem Bereich von zumindest 10 Hz und höchstens 100 GHz, von zumindest 1 MHz und höchstens 1 GHz oder von zumindest 10 MHz und höchstens 100 MHz, etwa 20 MHz aufweisen. Die reduzierte Abtastrate kann einen geringeren Wert aufweisen, etwa 12,2 MHz.

Das Informationssignal 16 kann von dem Vorwärtstransformator 12 als eine Zeitbereichsdarstellung empfangen werden. Der Vorwärtstransformator 12 kann ausgebildet sein, um die Zeitbereichsdarstellung im Zuge der Transformation in eine Frequenzbereichsdarstellung zu überführen. Die Transformation, etwa die Überführung in den Frequenzbereich, kann eine erste Transformationslänge aufweisen, etwa eine zumindest abschnittsweise Länge oder Frequenzbreite des Spektrogramms. Der Vorwärtstransformator 12 kann ausgebildet sein, um eine schnelle Fourier-Transformation (Fast Fourier Transformation - FFT) auf das Informationssignal 16 anzuwenden. Eine Transformationslänge kann sich auf eine Anzahl von Frequenzstützstellen oder Frequenzlinien der FFT-Transformation beziehen. Alternativ oder zusätzlich kann das Informationssignal 16 als Frequenzbereichsdarstellung empfangen werden. Eine Transformationslänge der FFT kann einen beliebigen Wert, etwa von zumindest $2^5$ und höchstens $2^{20}$, von zumindest $2^8$ und höchstens $2^{17}$ oder von zumindest $2^{10}$ und höchstens $2^{14}$ aufweisen. Die Transformationslänge der FFT kann auch einen Wert von weniger als $2^5$ aufweisen. Bevorzugt ist die Transformationslänge jedoch größer, da bei einer Länge von weniger als $2^5$ eine Anzahl von Koeffizienten für weitere Operationen gering oder zu gering sein kann. Eine Obergrenze für die Transformationslänge kann auch größer sein $2^{20}$ und ist bspw. von einer Kapazität eines verfügbaren Speichers und/oder einer Wortbreite beeinflusst. Jedoch kann bspw. eine Effizienz einer FFT schon bei einer Transformationslänge von weniger als $2^{20}$ ineffektiv sein, wenn der Rechenaufwand betrachtet wird. Eine Zunahme der Transformationslänge der FFT kann mit überproportionalem Rechenleistungsbedarf verbunden sein. So können bspw. eine Anzahl von N*ld(N) Operationen für eine Anzahl von N*(1-Overlap) Abtastwerte benötigt werden. Eine längere FFT kann also zusätzliche Rechenleistung pro Abtastwert erfordern, kann jedoch zu geringerem Aufwand für das Bereitstellen und Abholen der Daten führen. Ein höherer Wert der Transformationslänge kann zu einem Erhalten von einer höheren Anzahl von Koeffizienten für das Fenster in der Schnellen Faltung führen. Oberhalb von ca. 1.000 Koeffizienten kann jedoch bspw. ein praktischer Nutzen konstant bleiben oder lediglich gering zunehmen.

Die Vorrichtung 10 umfasst einen Prozessor 22 zum Bilden einer zweiten Version 24 des Spektrogramms. Die zweite Version 24 weist gegenüber der ersten Version 14 eine geringere Bandbreite auf. Dies kann vereinfacht als Bandbegrenzung verstanden werden. Der Prozessor 22 kann ausgebildet sein, um die erste Version 14 zu filtern. Alternativ oder zusätzlich kann der Prozessor 22 ausgebildet sein, um ein Frequenzfenster auf die erste Version 14 des Spektrogramms anzuwenden, so dass die zweite Version 24 basierend auf Frequenzanteilen (Frequenzbins) der ersten Version 14 erhalten wird, für die das erste Frequenzfenster ein Ergebnis (etwa einen Funktionsbetragswert oder eine Impulsantwort) aufweist, der größer ist als ein Schwellwert. Der Schwellwert kann beispielsweise einen Wert in einem Bereich von zumindest 0 und höchstens 0,5, von zumindest 0 und höchstens 0,25 oder von zumindest 0 und höchstens 0,1 eines maximalen Fensterbetragswerts oder Spektrogrammwerts aufweisen. Der Prozessor 22 kann ausgebildet sein, um Frequenzlinien (Frequenzbins), für die eine Multiplikation des Frequenzfensters mit der ersten Version 14 einen Wert ergibt, der kleiner ist als der vordefinierte Schwellwert, zu vernachlässigen. Vereinfacht ausgedrückt können alle Frequenzbins außerhalb des Fensters und/oder unterhalb des Schwellwertes weggelassen werden, so dass eine reduzierte und ggf. gewichtete Anzahl von Frequenzbins der ersten Version 14 in die zweite Version 24 des Spektrogramms übernommen wird. Alternativ kann das Frequenzfenster bspw. als Filter implementiert sein, etwa als (FIR-Filter = Finite Impulse Response Filter, Filter mit endlicher Impulsantwort).

Die Vorrichtung 10 umfasst einen Rückwärtstransformator 26 zum Bilden eines grob vorveränderten Informationssignals 28. Das grob vorveränderte Informationssignal 28 weist eine zweite Abtastrate auf. Die zweite Abtastrate ist gegenüber der ersten Abtastrate des Informationssignals 16 verändert, bspw. reduziert. Der Rückwärtstransformator 26 ist ausgebildet, um mittels einer Rücktransformation der zweiten Version 24 des Spektrogramms das vorveränderte Informationssignal 28 zu bilden. Das vorveränderte Informationssignal kann ein vordezimiertes Informationssignal sein oder ein Signal mit einer gleichen oder erhöhten Bandbreite oder Abtastrate,

Die Rückwärtstransformation der zweiten Version 24 des Spektrogramms weist eine Transformationslänge auf, die gegenüber der ersten Transformationslänge der Transformation, die von dem Vorwärtstransformator 12 ausführbar ist, verändert ist. Bspw. kann die zweite Transformationslänge einen doppelten, dreifachen oder vierfachen Wert aufweisen als die erste Transformationslänge. Weist das Informationssignal bspw. eine Abtastrate von 20 MHz auf, kann das vorveränderte Informationssignal eine Abtastrate von 40 MHz, 60 MHz bzw. 80 MHz aufweisen. Alternativ kann das vorveränderte Informationssignal auch eine verringerte Abtastrate aufweisen, etwa 5 MHz, 10 MHz oder 15 MHz.

Vereinfacht ausgedrückt ist der Rückwärtstransformator 26 ausgebildet, um die zweite Version 24 in den Zeitbereich zurück zu überführen. Beispielsweise kann der Rückwärtstransformator 26 ausgebildet sein, um eine inverse FFT (IFFT) auszuführen mit einer Transformationslänge auszuführen. Die Transformationslänge der IFFT kann ein Vielfaches der Transformationslänge der FFT sein (oder andersherum). Der Rückwärtstransformator 26 kann ausgebildet sein, um ein Overlap&Add oder ein Overlap&Save-Verfahren auf ein Ergebnis der Rücktransformation anzuwenden, um das grob vorveränderte Informationssignal 28 zu erhalten. Vereinfacht ausgedrückt ist der Rückwärtstransformator 26 ausgebildet, um eine Rückwandlung der zweiten Version 24 in den Zeitbereich auszuführen, etwa mittels IFFT. Der Rückwärtstransformator 26 kann ausgebildet sein, um nachfolgend ein Overlap&Add- oder ein Overlap&Save-Verfahren auszuführen.

Die Vorrichtung 10 umfasst einen Zeitbereichsinterpolator 32, der ausgebildet ist, um ein Informationssignal 34 mit einer dritten Abtastrate mittels einer Interpolation des vorveränderten Informationssignals 28 zu erhalten. Die dritte Abtastrate ist gegenüber der zweiten Abtastrate verändert Die dritte Abtastrate kann gegenüber der zweiten Abtastrate erhöht oder verringert sein. Beispielsweise kann der Zeitbereichsinterpolator 32 ausgebildet sein, um das Informationssignal 34 basierend auf einer Polynominterpolation zu erhalten. Beispielsweise kann der Zeitbereichsinterpolator 32 ausgebildet sein, um eine Lagrange-Interpolation auszuführen. Der Zeitbereichsinterpolator 32 kann ausgebildet sein, um ein Ergebnis der Interpolation weiterzuverarbeiten oder auszuwerten, etwa mittels eines Horner-Schemas. Basierend auf der Rückwärtstransformation mit einer zweiten, gegenüber der ersten Transformationslänge verringerten Transformationslänge kann eine erste Dezimation des Informationssignals 16 erhalten werden. Bspw. kann die zweite Abtastrate 80 MHz und die dritte Abtastrate 12,2 MHz betragen, so dass das Informationssignal 34 bezogen auf das Informationssignal 16 dezimiert ist. Das bedeutet, dass eine Differenz zwischen der ersten und der dritten Abtastrate (etwa 20 MHz und 12,2 MHz) betragsmäßig kleiner sein kann als eine Differenz zwischen der zweiten und dritten Abtastrate (etwa 80 MHz und 12,2 MHz).

Der Prozessor 22 kann ausgebildet sein, um eine Anzahl von Frequenzbins, die die erste Version 14 des Spektrogramms aufweist, mit Frequenzlinien zu ergänzen, die einen vordefinierten Wert der Amplitude oder Magnitude aufweisen. Beispielsweise kann es sich bei dem vordefinierten Wert um einen Wert in einem Bereich von zumindest 0 und höchstens 0,5, zumindest 0 und höchstens 0,2 und zumindest 0 und höchstens 0,1 eines maximalen möglichen Werts handeln, beispielsweise 0. Der Prozessor kann ausgebildet sein, um die Anzahl der Frequenzlinien der zweiten Version mittels der vordefinierten Frequenzlinien zu ergänzen, so dass in Summe eine Anzahl von Frequenzlinien erhalten wird, die einem Wert der kleinsten Potenz der Zahl 2 mit einer natürlichen Zahl entspricht und gleichzeitig größer oder gleich der Anzahl von Frequenzlinien der zweiten Version 24 ist. Vereinfacht ausgedrückt kann die Anzahl von Frequenzbins mit Werten, etwa Nullen, aufgefüllt werden, um auf die nächstgrößere Anzahl gemäß einer Zweierpotenz zu kornmen. Das beschriebene Auffüllen ermöglicht somit den Erhalt einer für IFFT-Verfahren wünschenswerten Anzahl von Ziffer $2^n$ Frequenzbins. Durch das Auffüllen ist eine (synthetische) eine Generierung von Informationen reduziert oder verhindert, so dass die Rückwärtstransformation mit einem geringen Rechenaufwand ausführbar ist.

Zusätzlich kann der Prozessor ausgebildet sein, um der ersten Anzahl von Frequenzlinien eine dritte Anzahl von Frequenzlinien mit dem vordefinierten Wert hinzuzufügen. Die dritte Anzahl kann einer weiteren Potenz der Zahl 2 mit einer natürlichen Zahl abzüglich 1 entsprechen, so dass sich insgesamt aus der Summe der ersten Anzahl, der zweiten Anzahl und der dritten Anzahl wieder ein Wert einer Potenz der Zahl 2 mit einer natürlichen Zahl ergibt. Die dritte Anzahl kann bspw. der Summe der ersten Anzahl und der zweiten Anzahl entsprechen, so dass die dritte Anzahl zu einer Verdopplung, d.h. Faktor 2 bzw. Ziffer $2^1$ erhalten wird. Alternativ kann die dritte Anzahl der dreifachen Anzahl der Summe der ersten Anzahl und der zweiten Anzahl entsprechen, so dass insgesamt eine vierfache Anzahl der Summe der ersten und zweiten Anzahl, d.h. Faktor 4 und mithin Ziffer $2^2$, erhalten wird.

Die Vorrichtung 10 ist ausgebildet, um ein Informationssignal 36 auszugeben, das auf dem Informationssignal 34 basiert.

Mittels der Interpolation des Zeitbereichsinterpolators kann die dritte Abtastrate gegenüber der zweiten Abtastrate erhöht oder erniedrigt werden. Eine Differenz zwischen der zweiten Abtastrate und der dritten Abtastrate kann geringer sein als eine Differenz der zweiten Abtastrate und der ersten Abtastrate. Das Informationssignal 34 kann auch als fein verändertes oder dezimiertes Informationssignal bezeichnet werden.

Die Interpolation ermöglicht ein Erhalten der zweiten Abtastrate, wobei hier gegebenenfalls bspw. einige feste Verhältnisse zwischen der ersten Abtastrate und zweiten Abtastrate bestimmt werden, um eine hohe Berechnungseffizienz zu erhalten. Eine Feinabstimmung der Abtastrate kann durch eine nachträgliche Interpolation der zweiten Abtastrate erhalten werden, wobei diese basierend auf der bereits erfolgten grob vorveränderten Abtastrate einen geringen Berechnungsaufwand aufweist und zu geringen oder vernachlässigbaren Interpolationsfehlern führt, Die Interpolation kann dabei auf einen Komplexitätsgrad beschränkt werden, der kleiner oder gleich ist als ein Komplexitätsgrad, der benötigt wird, um eine Interpolationsrate zwischen zwei festen Stufen des Verhältnisses der ersten und der zweiten Abtastrate zu bestimmen. Vereinfacht ausgedrückt kann die Interpolation lediglich für Zwischenbereiche von Abtastraten eingesetzt werden, die zwischen zwei Abtastraten des grob vorveränderten Informationssignals 28 liegt. Alternativ kann eine Differenz zwischen der ersten und zweiten Abtastrate auch kleiner sein, als eine Differenz zwischen der zweiten und dritten Abtastrate.

Der Zeitbereichsinterpolator 32 kann ausgebildet sein, um einen Abtastwert der dritten Abtastrate des Informationssignals 34 basierend auf zumindest zwei Abtastwerten der zweiten Abtastrate des vorveränderten Informationssignals 28 zu erhalten. Eine Polynominterpolation kann mit einem Grad ausgeführt werden, der auf einer Anzahl von vorhandenen Abtastwerten des vorveränderten Informationssignals 28 basiert, die für den Erhalt eines Abtastwertes genutzt wird. So kann bspw. ein Abtastwert des Informationssignals 34 zwischen einer Mehrzahl von Abtastwerten des grob vorveränderten Informationssignals 28 angeordnet sein. Ein maximaler Grad der Polynominterpolation kann bspw. der Mehrzahl von Abtastwerten abzüglich 1 entsprechen. Eine Anzahl von Abtastwerten, die für die Interpolation oder Polynominterpolation verwendet werden, kann in einem Bereich von zumindest zwei und höchstens acht, zumindest zwei und höchstens sieben oder in einem Bereich von zumindest drei und höchstens fünf Abtastwerten liegen. Die Polynominterpolation kann mit einem Grad ausgeführt werden, der in einem Bereich zwischen 1 und 7, zwischen 1 und 6 oder zwischen 2 und 4 liegt.

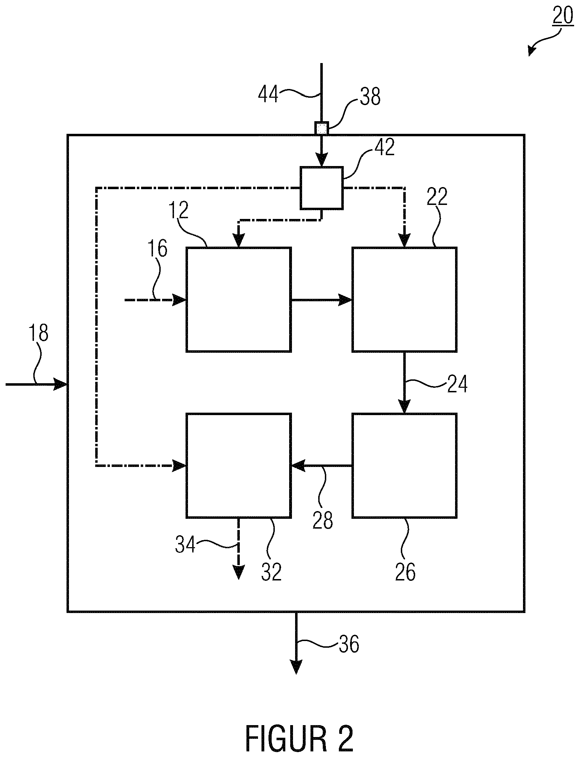

Fig. 2 zeigt ein schematisches Blockschaltbild einer Vorrichtung 20 zum Verändern einer Abtastrate. Die Vorrichtung 20 weist verglichen mit der Vorrichtung 10 ferner einen Signaleingang 38 und ein Steuerelement 42 auf. Die Vorrichtung ist ausgebildet, um mittels des Signaleingangs 38 ein Eingangssignal 44 zu empfangen. Bei dem Eingangssignal 44 kann es sich beispielsweise um eine Benutzereingabe handeln. Das Eingangssignal kann eine Anweisung enthalten, die sich auf eine einzustellende Abtastrate des fein veränderten Signals, auf ein Verhältnis zwischen Eingangs- und Ausgangsabtastrate oder auf eine Dezimationsrate bezieht. Das Eingangssignal 44 kann eine Vorgabe bezüglich einer Abtastrate aufweisen. Hierbei kann es sich um die erste, zweite und/oder dritte Abtastrate handeln.

Das Steuerelement 42 kann ausgebildet sein, um den Vorwärtstransformator 32 zu steuern. Die Steuerung kann sich auf eine Länge der ersten Transformationslänge beziehen, das bedeutet, das Steuerelement 42 kann ausgebildet sein, um den Vorwärtstransformator zu steuern, so dass eine Länge der ersten Transformationslänge verändert wird. Alternativ oder zusätzlich kann das Steuerelement 42 ausgebildet sein, um den Prozessor 22 zu steuern, so dass eine Länge der zweiten Transformationslänge verändert wird. Dies kann beispielsweise basierend auf einer Veränderung des Frequenzfensters und/oder basierend auf einer Veränderung des Schwellwerts zur Selektion von Frequenzbereichslinien erfolgen. Vereinfacht ausgedrückt, kann das Steuerelement 42 ausgebildet sein, um ein Verhältnis zwischen der ersten Abtastrate und der zweiten Abtastrate basierend auf einer Veränderung der ersten Abtastrate und/oder der zweiten Abtastrate zu beeinflussen.

Alternativ oder zusätzlich kann das Steuerelement 42 ausgebildet sein, um den Zeitbereichsinterpolator 32 zu steuern, so dass dieser die dritte Abtastrate des Informationssignals 34 ändert oder einstellt. Die Steuerung des Zeitbereichsinterpolators 32 kann beispielsweise mittels einer Vorgabe, in welchen Abständen Abtastwerte aus dem grob vorveränderten Informationssignal 28 interpoliert werden sollen, erfolgen.

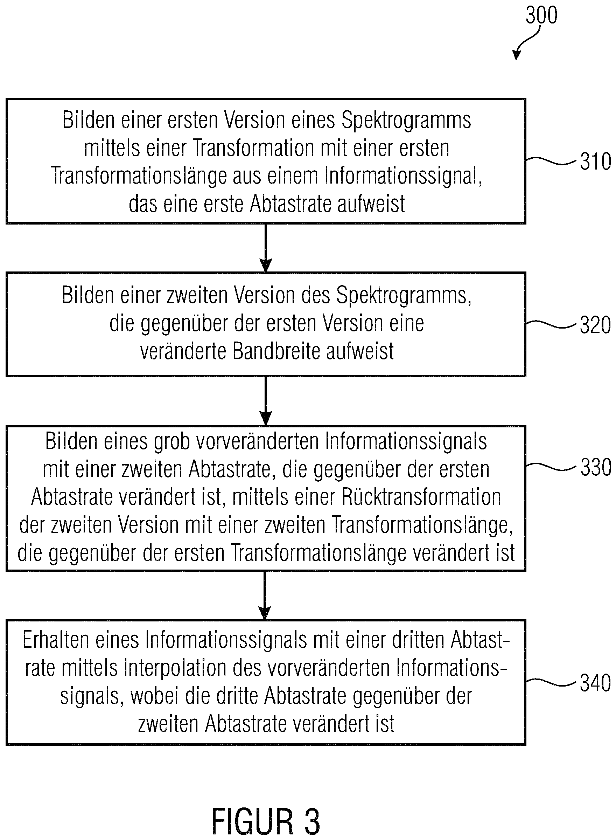

Fig. 3 zeigt ein schematisches Flussdiagramm eines Verfahrens 300 zum Verändern einer Abtastrate. Das Verfahren 300 umfasst einen Schritt 310, in dem eine erste Version eines Spektrogramms mittels einer Transformation mit einer ersten Transformationslänge aus einem Informationssignal, das eine erste Abtastrate aufweist, gebildet wird. Hierfür können Zeitbereichsdaten, die beispielsweise von einem Analog-Digital-Umsetzer erhalten werden, in den Frequenzbereich umgewandelt werden. Hierfür kann auch ein sogenanntes "Zero-Padding" eingesetzt werden. Die Umwandlung kann mittels einer FFT, die eine Länge N1 aufweist, erfolgen.

Ein Schritt 320 umfasst ein Bilden einer zweiten Version des Spektrogramms, das gegenüber der ersten Version eine geringere Bandbreite aufweist. Hierfür kann ein multiplikatives Fenster oder ein Filter (bspw. FIR) angewendet werden, um einen gewünschten Frequenzbereich mit N2 Koeffizienten auszuwählen, wobei bspw. N2 ≤ N1 oder N2 ≥ N1 ist. Das multiplikative Fenster oder das FIR-Filter kann beispielsweise mittels des Prozessors 22 angewendet werden. Frequenzbins außerhalb des Fensters oder nicht von dem FIR-Filter zurückgegeben können weggelassen werden, so dass die N2 Frequenzbins übrigbleiben.

Ein Schritt 330 umfasst ein Bilden eines grob vorveränderten Informationssignals mit einer zweiten Abtastrate, die gegenüber der ersten Abtastrate verändert, bspw. erhöht ist, mittels einer Rücktransformation der zweiten Version mit einer zweiten Transformationslänge, die gegenüber der ersten Transformationslänge verändert ist. Beispielsweise kann dies basierend auf einer Rückwandlung der zweiten Version in den Zeitbereich erfolgen. Die Rückwandlung kann mittels einer IFFT der Länge N3 und gegebenenfalls nachfolgendem Overlap&Add oder Overlap&Save erfolgen. Der Wert N3 kann gleich dem Wert N2 sein. Alternativ kann der Wert N3 auch eine Potenz der Zahl 2 mit einer natürlichen Zahl sein, die größer ist als der Wert eines natürlichen Logarithmus der Zahl N2. Beispielsweise kann der Prozessor ausgebildet sein, um die Anzahl von N2 Frequenzbins mit einer Anzahl von Frequenzbins mit vordefinierten Werten (etwa Nullen) aufzufüllen, um auf eine Zweierpotenz zu kommen. Dies kann darstellbar sein durch

$$N3 = 2^{(ceil(ld(N2))+nOvs1)}$$

Der Parameter nOvs1 kann als Überabtastungsparameter bezeichnet werden und einen Wert von 0 oder einer natürlichen Zahl aufweisen. Der Ausdruck ceil(ld(N2)) kann so verstanden werden, dass einer ersten Anzahl von Frequenzlinien der zweiten Version eine zweite Anzahl von Frequenzlinien mit einem vordefinierten Wert hinzugefügt werden, das Hinzufügen kann mittels einer Aufrundfunktion (ceil) darstellbar sein. Die zweite Anzahl kann der durch das Aufrunden hinzugefügten Anzahl von Frequenzbins entsprechen. Eine Summe der ersten Anzahl und der zweiten Anzahl kann der aufgerundeten, kleinsten Potenz der Zahl 2 mit einer natürlichen Zahl entsprechen, wobei das Ergebnis der Potenz der Zahl 2 mit der natürlichen Zahl größer oder gleich der ersten Anzahl ist.

Der Überabtastungsparameter nOvs1 kann beispielsweise einen Wert von zumindest 0 und höchstens 5, von zumindest 0 und höchstens 3 oder von zumindest 0 und höchstens 2 aufweisen. Weist der Parameter nOvs1 beispielsweise den Wert 1 auf, weist die dritte Anzahl den Wert der Summe der ersten und zweiten Anzahl auf, d.h. es wird eine Verdoppelung erhalten. Weist der Parameter nOvs1 beispielsweise den Wert 2 auf, so wird beispielsweise die Potenz mit einem um 2 erhöhten Exponenten erhalten, so dass eine Vervierfachung erhalten wird, was bedeutet, dass die dritte Anzahl dem Dreifachen der Summe der ersten und zweiten Anzahl entspricht.

Ein Schritt 340 umfasst ein Erhalten eines Informationssignals mit einer dritten Abtastrate, die gegenüber der zweiten Abtastrate verändert ist mittels Interpolation des vorveränderten Informationssignals.

Der vorangehend beschriebene Parameter nOvs1 kann beispielsweise auch den Wert 0 aufweisen, etwa um die zweite Transformationslänge, repräsentierbar durch die Anzahl N3, nicht zu groß werden zu lassen, was zu einem geringen Speicherbedarf führen kann.

Beispielsweise kann in einem derartigen Fall eine Anzahl von $2^{nOvs2}$-Fenstern genutzt werden, die auf die erste Version des Spektrogramms angewendet werden, etwa unter Verwendung des Prozessors. Die zweite Version des Spektrogramms kann basierend auf Frequenzanteilen, für die die erste und das zumindest zweite Frequenzfenster einen Funktionsbetragswert aufweisen, der größer als der Schwellwert ist, erhalten werden. Das erste Frequenzfenster und das zumindest zweite Frequenzfenster können eine zueinander verschobene Gruppenlaufzweit aufweisen. Beispielsweise kann in dem Schritt 320 ein paralleles Anwenden von $2^{nOvs2}$-Fenstern mit gleichem Betragsfrequenzgang und gegeneinander versetzten Gruppenlaufzeiten erfolgen. Die erste Anzahl (N2) von Frequenzbins kann mit den vordefinierten Werten aufgefüllt werden, um auf die nächstgrößere Zweierpotenz zu kommen, etwa gemäß $N3 = 2^{(ceil(ld(N2)))}$ Die Parameter nOvs1 und nOvs2 können eine wechselseitige Beziehung zueinander aufweisen. Bspw. kann die Beziehung derart formuliert werden, dass die Parameter nOvs1 und nOvs2 einen veränderlichen Wert aufweisen während eine Summe der Parameter einen konstanten Wert aufweist, 0 und höchstens 5, von zumindest 0 und höchstens 3 oder von zumindest 0 und höchstens 2 aufweisen. Dies kann vereinfacht in einem vorbestimmten Maß der Überabtastung verstanden werden, die ganz oder teilweise durch Auffüllen der Frequenzbins (nOvs1) und/oder ganz oder teilweise durch Erhalten einer erhöhten Anzahl von Frequenzbins während der Fensterung (nOvs2) ermöglicht ist.

Der Rückwärtstransformator kann ausgebildet sein, um eine parallele Rücktransformation gegebenenfalls einschließlich Overlap&Add oder Overlap&Save und nachfolgendem Interleaving der erhaltenen Ausgangsdaten auszuführen, so dass wieder ein Zeitbereichsdatenstrom entsteht, der um den Faktor $2^{nOvs}$ interpoliert ist. Vereinfacht ausgedrückt wird so anstelle der erhöhten Anzahl von vordefinierten Werten eine erhöhte Anzahl von mittels des Frequenzfensters erhaltenen Werten erhalten.

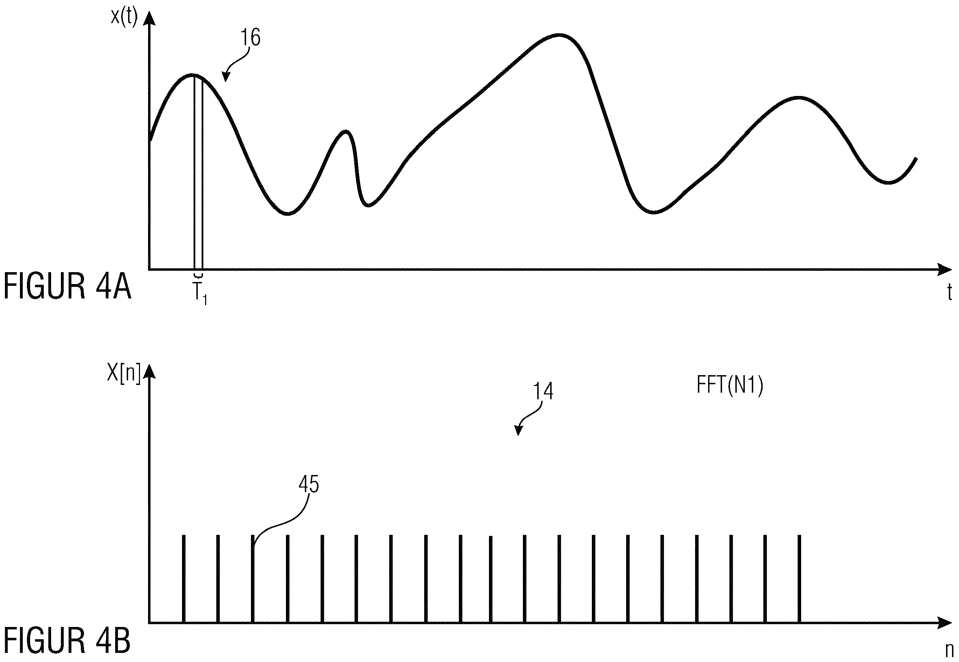

Fig. 4a zeigt einen schematischen Verlauf des Informationssignals 16 im Zeitbereich. Eine Amplitude x(t) des Informationssignals 16 ist über eine Zeitachse t aufgetragen. Das Informationssignal 16 weist eine Abtastrate $1/T_1$ auf.

Fig. 4b zeigt schematisch die erste Version 14 des Spektrogramms, bei dem eine Anzahl von N1 Frequenzbins 45 erhalten werden, etwa basierend auf einer FFT der Transformationslänge N1. Die Frequenzbins 45 sind vereinfacht als äquidistante Linien mit gleichen Amplituden dargestellt, können aber von einander verschiedene Frequenzabstände und/oder von einander verschiedene Amplituden aufweisen. Das Spektrogramm zeigt eine vereinfachte Darstellung, bei der an der Abszisse n die Frequenzbins und die Ordinate X[n] die Amplitude bezeichnet.

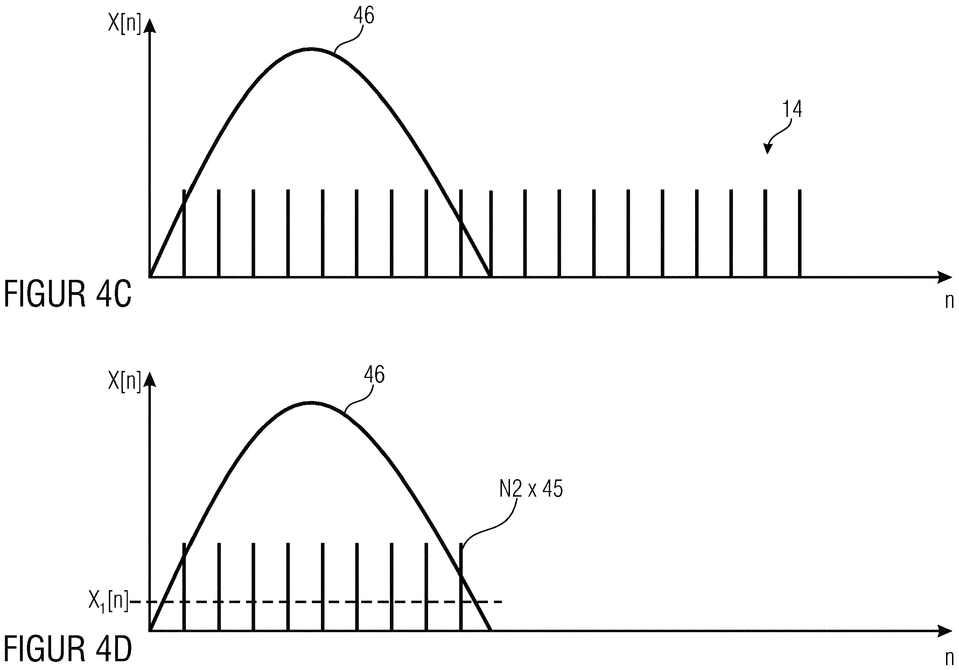

Fig. 4c zeigt schematisch eine Anwendung eines Frequenzfensters 46 auf die erste Version 14, wie es beispielsweise im Zusammenhang mit dem Prozessor beschrieben ist. Bei dem Frequenzfenster 46 kann es sich um ein beliebiges Frequenzfenster handeln. Bspw. kann das Frequenzfenster 46 eine Fensterfunktion umfassen, etwa ein Cosinus-Fenster, ein Hamming-Fenster, ein Gauß-Fenster, ein Rechteck-Fenster oder dergleichen. Alternativ kann die das Frequenzfenster 46 auch als FIR-Filter implementiert sein. Eine Impulsantwort des FIR Filters kann ein Ergebnis einer Anwendung des Frequenzfensters auf ein Signal sein.

Fig. 4d zeigt ein schematisches Weglassen von Frequenzbins, für die ein Betragswert der Fensterfunktion 46 einen Schwellwert $X_1[n]$ unterscheidet. Alternativ können auch Frequenzbins entfernt werden, für die eine Multiplikation der Amplitude des jeweiligen Frequenzbins 45 den Schwellwert $X_1[n]$ unterschreitet. Wird vereinfachend ein Rechteckfenster betrachtet, so kann dies auf Frequenzbins zutreffen, die außerhalb des Fensters angeordnet sind. Wird alternativ ein FIR-Filter betrachtet, so kann dies auf Frequenzbins zutreffen, für die das FIR-Filter keine Impulsantwort liefert oder auf Frequenzbins, deren Impulsantwort unberücksichtigt bleibt. Ist das Frequenzfenster bspw. als FIR Filter ausgeführt, so können die Frequenzbins 45 eine Impulsantwort des FIR-Filters sein, die basierend auf der ersten Version 14, von dem FIR-Filter erhalten wird. Basierend auf dem Frequenzfenster kann eine Anzahl von N2 Frequenzbins 45 erhalten werden.

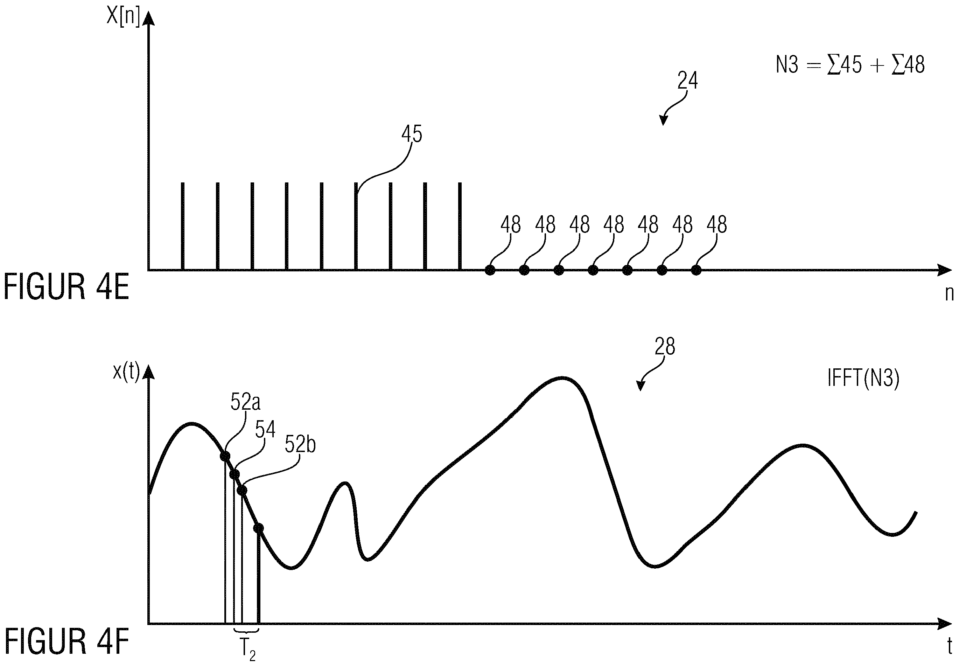

Fig. 4e zeigt schematisch ein Hinzufügen von vordefinierten Werten 48 zu den Frequenzbins 45, um die zweite Version 24 zu erhalten. Die vordefinierten Werte 48 sind bspw. ebenfalls Frequenzbins mit einem vordefinierten Wert. Der vordefinierte Wert weist beispielsweise einen Amplitudenwert von $X[n]$ von 0 auf. Eine Anzahl von Frequenzbins 45 und vordefinierten Werten 48 entspricht beispielsweise 16 (9 Frequenzbins 45 und 7 vordefinierte Werte 48), so dass insgesamt eine Anzahl von $16 = 2^4$ Werten erhalten wird. Die erste Anzahl kann somit beispielsweise 9 betragen. Die zweite Anzahl kann beispielsweise 7 betragen, wobei eine zweite Transformationslänge beispielsweise 16 betragen kann. Die dargestellten Zahlenwerte sind beispielhaft zu verstehen. Ausführungsbeispiele beziehen sich auf Transformationslängen in einem Bereich von zumindest $2^5$ und höchstens $2^{20}$, von zumindest $2^8$ und höchstens $2^{17}$ oder von zumindest $2^{10}$ und höchstens $2^{14}$. Die zweite Version 24 weist verglichen mit der ersten Version 14 eine verringerte Bandbreite auf. Ist das Frequenzfenster 46 bspw. als FIR-Filter implementiert, so kann die Impulsantwort des FIR-Filters mit den vordefinierten Werten aufgefüllt werden.

Fig. 4f zeigt schematisch einen Verlauf des grob vordefinierten Informationssignals 28 im Zeitbereich. Wie es im Zusammenhang mit dem Zeitbereichsinterpolator 32 beschrieben ist, kann basierend auf Abtastwerten (Zeitbereichssamples) 52a und 52b, zwischen denen ein zu erhaltener Abtastwert 54 angeordnet ist, eine einer Abtastrate $1/T_2$, einer Mehrzahl von Abtastwerten 54 erhalten werden. Die Abtastrate $1/T_2$ kann kleiner sein, als die Abtastrate $1/T_1$. Die Abtastrate $1/T_2$ des erhaltenen Informationssignals kann bezüglich der Abtastrate des vorveränderten Informationssignals erhöht oder verringert sein.

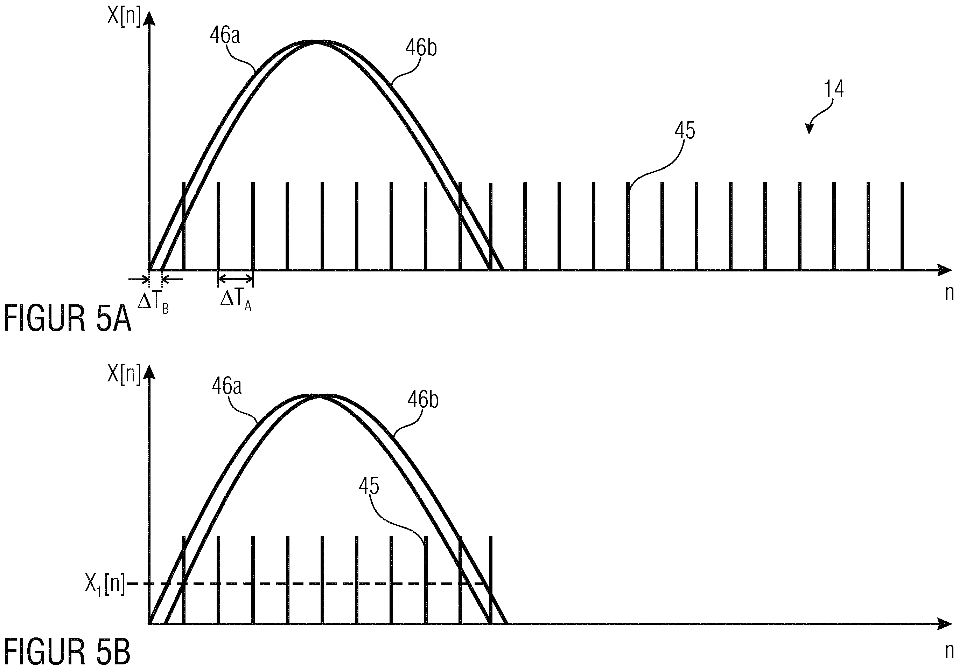

Fig. 5a zeigt schematisch eine Anwendung eines ersten Frequenzfensters 46a und eines zweiten Frequenzfenster 46b auf die Frequenzbins 45 der ersten Version 14. Verglichen mit der Fig. 4c wird eine erhöhte Anzahl von Frequenzbins 45 mit den Frequenzfenstern 46a und 46b multipliziert oder erhalten. Vereinfacht ausgedrückt ermöglicht das Frequenzfenster 46a einen Erhalt einer ersten Teilmenge von Frequenzbins 45 und das Frequenzfenster 46b einen Erhalt einer zweiten Teilmenge von Frequenzbins 45.

Die Frequenzfenster 46a und 46b können einen gleichen oder vergleichbaren Betragsfrequenzgang und zueinander versetzte Gruppenlaufzeiten aufweisen. Die Gruppenlaufzeiten können einen beliebigen Versatz $\Delta T_B$ aufweisen. Bspw. kann ein aufsummierter Versatz der Gruppenlaufzeiten der Frequenzfenster in etwa einer Zeitdifferenz $\Delta T_A$ zwischen zwei Abtastwerten der ersten Version entsprechen, etwa in einem Toleranzbereich von 100 %, 50 % oder 10 %. Die Abbildung der Fig. 5a ist in Bezug auf dargestellte Zeitverschiebungen schematisch zu verstehen und bezieht sich diesbezüglich auf Abtastwerte.

Ist der Prozessor bspw. ausgebildet, um ein erstes und eine zweites Frequenzfenster anzuwenden, kann ein Versatz $\Delta T_B$ der Gruppenlaufzeit bspw. 50 % der Zeitdifferenz $\Delta T_A$ zwischen zwei Abtastwerten entsprechen. Ist der Prozessor bspw. ausgebildet, um vier Frequenzfenster anzuwenden, kann ein Versatz des zweiten, dritten und vierten Frequenzfensters zu dem ersten Frequenzfenster bspw. 25 %, 50 % bzw. 75 % der Zeitdifferenz zwischen zwei Abtastwerten entsprechen.

Fig. 5b zeigt schematisch ein Weglassen von Frequenzbins 45, für die ein Wert der Multiplikation der Frequenzbins 45 mit den Frequenzfenstern 46a und/oder 46b oder der Betragswert der Frequenzfenster 46a und 46b den Schwellwert $X_1[n]$ unterschreitet. Alternativ können die Frequenzbins durch eine Anwendung eines ersten FIR-Filters und eines zweiten FIR-Filters bzw. durch mehrfach-Nutzung eines FIR-Filters erhalten werden.

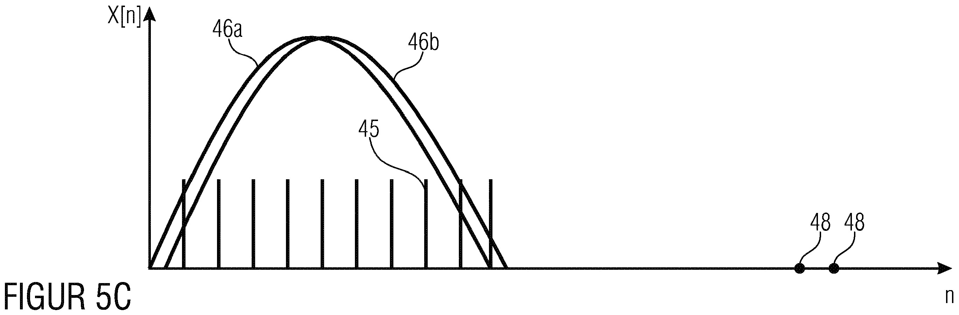

Fig. 5c zeigt das Hinzufügen der vordefinierten Werte 48 gemäß der Fig. 4e, wobei basierend auf der durch die erhöhte Anzahl von Frequenzfenstern erhöhten Anzahl von Frequenzbins 45 (erste und zweite Teilmenge) eine geringere Anzahl von Füllwerten (Werte 48) benötigt werden kann, um auf die nächstgrößere Zweierpotenz zu kommen.

Vorangehend beschriebene Ausführungsbeispiele nutzen in besonders vorteilhafter Weise die Anwendung eines oder mehrerer multiplikativer Fenster. Dies ermöglicht ohne zusätzlichen Rechenaufwand, eine passgenaue Bandbegrenzung der Eingangsdaten. Durch die Anwendung einer schnellen Faltung (FFT) können dabei steilflankige Filter realisierbar sein. Mittels des Ergänzens der Frequenzbins mit den vordefinierten Werten kann erreicht werden, dass für die Rücktransformation eine schnelle Implementierung der IFFT verwendet werden kann, etwa wenn der Parameter nOvs gleich 0 ist. Weist der Parameter nOvs einen anderen Wert auf, etwa 1 oder 2, so kann an dieser Stelle eine Interpolation der Daten um den Faktor 2 oder 4 erfolgen. Dies kann die Polynominterpolation des Zeitbereichsinterpolators entlasten und eine hohe Signalqualität mit SFDR-Werten von größer 60 dB, größer 70 dB oder größer 80 dB ermöglichen.

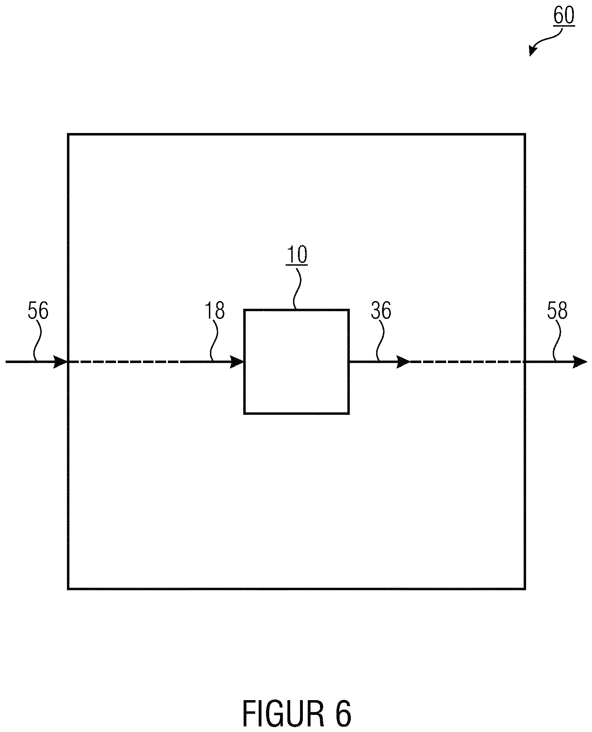

Fig. 6 zeigt ein schematisches Blockschaltbild eines Systems 60, das die Vorrichtung 10 aufweist. Bei dem System 60 kann es sich beispielsweise um einen Hochfrequenzempfänger handeln. Alternativ kann auch die Vorrichtung 20 angeordnet sein. Das System 60 ist ausgebildet, um ein Signal 56 zu empfangen und basierend auf dem Signal 56 das Informationssignal 18 bereitzustellen. Das System 60 kann ausgebildet sein, um ein Signal 58, das auf dem Informationssignal 36 oder 34 basiert, auszugeben. Bei dem Signal 58 kann es sich um ein Signal handeln, dass eine Information zur graphischen Darstellung des Informationssignals 36 aufweist, handeln. Alternativ kann es sich bei dem Signal 58 auch um das Signal 36 und/oder um ein Hochfrequenzsignal handeln. Bei dem Signal 56 kann es sich um ein Hochfrequenzsignal handeln. Das System kann bspw. Teil einer Empfangsvorrichtung sein.

In anderen Worten können Ausführungsbeispiele bei Hochfrequenzempfängern eingesetzt werden. Die Hochfrequenzempfänger können ausgebildet sein, die empfangenen Signale digital zu verarbeiten. Bei Ausführungsbeispielen kann es vorteilhaft sein, wenn die empfangen Signale bereits in der Frequenzbereich transformiert wurden.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1. Vorrichtung zum Verändern einer Abtastrate mit:

einem Vorwärtstransformator (12) zum Bilden einer ersten Version (14) eines Spektrogramms in einer Frequenzbereichsdarstellung mittels einer Fourier-Transformation mit einer ersten Transformationslänge (N1) aus einem in einer Zeitbereichsdarstellung erhaltenem Informationssignal (16), das eine erste Abtastrate ($1/T_1$) aufweist;

einem Prozessor (22) zum Bilden einer zweiten Version (24) des Spektrogramms aus der ersten Version vermittels einer Bandbegrenzung, die gegenüber der ersten Version (14) eine geringere Bandbreite aufweist;

wobei die zweite Version (24) des Spektrogramms mit einer ersten Anzahl (N2) von Frequenzlinien (45) darstellbar ist, wobei der Prozessor (22) ausgebildet ist, um der ersten Anzahl (N2) eine zweite Anzahl von Frequenzlinien (48) mit einem vordefinierten Wert hinzuzufügen, wobei eine Summe der ersten Anzahl (N2) und der zweiten Anzahl der kleinsten Potenz der Zahl zwei mit einer natürlichen Zahl entspricht, die größer als oder gleich der ersten Anzahl (N2) ist;

einem Rückwärtstransformator (26) zum Bilden eines grob vorveränderten Informationssignals (28) mit einer zweiten Abtastrate, die gegenüber der ersten Abtastrate ($1/T_1$) verändert ist, mittels einer Rücktransformation durch eine inverse Fourier-Transformation der zweiten Version (24) des Spektrogramms mit einer zweiten Transformationslänge (N3), die der Summe entspricht und die gegenüber der ersten Transformationslänge (N1) verändert ist; und

einem Zeitbereichsinterpolator (32) zum Erhalten eines Informationssignals (34) mit einer dritten Abtastrate (1/T2), die gegenüber der zweiten Abtastrate verändert ist, mittels Interpolation des vorveränderten Informationssignals (28).

2. Vorrichtung gemäß Anspruch 1, bei der der Zeitbereichsinterpolator (32) ausgebildet ist, um das Informationssignal (34) mit der dritten Abtastrate ($1/T_2$) so zu interpolieren, dass eine Differenz zwischen der erste Abtastrate und der dritten ($1/T_2$) Abtastrate geringer ist, als eine Differenz zwischen der zweiten Abtastrate und der dritten ($1/T_1$) Abtastrate, wobei das Informationssignal (34) mit der dritten Abtastrate ein fein verändertes Informationssignal ist.

3. Vorrichtung gemäß Anspruch 1 oder 2, bei der der Zeitbereichsinterpolator (32) ausgebildet ist, um das Informationssignal (34) mit der dritten Abtastrate ($1/T_2$) so zu interpolieren, dass die dritte Abtastrate ($1/T_2$) gegenüber der zweiten Abtastrate verringert ist.

4. Vorrichtung gemäß einem der vorangehenden Ansprüche, bei der der Zeitbereichsinterpolator (32) ausgebildet ist, um Abtastwerte (54) der dritten Abtastrate ($1/T_2$) mittels einer Polynominterpolation zu erhalten, wobei die Polynominterpolation auf Abtastwerten (52a, 52b) der zweiten Abtastrate basiert.

5. Vorrichtung gemäß Anspruch 4, bei der der Zeitbereichsinterpolator (32) ausgebildet ist, um einen Abtastwert (54) der dritten Abtastrate ($1/T_2$) basierend auf zumindest zwei und höchstens acht Abtastwerten (52a, 52b) der zweiten Abtastrate zu erhalten oder um die Polynominterpolation mit einem Grad auszuführen, wobei der Grad einen Wert von zumindest 1 und höchstens 7 aufweist.

6. Vorrichtung zum Verändern einer Abtastrate mit:

einem Vorwärtstransformator (12) zum Bilden einer ersten Version (14) eines Spektrogramms mittels einer Fourier-Transformation mit einer ersten Transformationslänge (N1) aus einem in einer Zeitbereichsdarstellung erhaltenem Informationssignal (16), das eine erste Abtastrate ($1/T_1$) aufweist;

einem Prozessor (22) zum Bilden einer zweiten Version (24) des Spektrogramms vermittels einer Bandbegrenzung, die gegenüber der ersten Version (14) eine geringere Bandbreite aufweist;

einem Rückwärtstransformator (26) zum Bilden eines grob vorveränderten Informationssignals (28) mit einer zweiten Abtastrate, die gegenüber der ersten Abtastrate ($1/T_1$) verändert ist, mittels einer Rücktransformation durch eine inverse Fourier-Transformation der zweiten Version (24) des Spektrogramms mit einer zweiten Transformationslänge (N3), die gegenüber der ersten Transformationslänge (N1) verändert ist; und

einem Zeitbereichsinterpolator (32) zum Erhalten eines Informationssignals (34) mit einer dritten Abtastrate (1/T2), die gegenüber der zweiten Abtastrate verändert ist, mittels Interpolation des vorveränderten Informationssignals (28); wobei der Prozessor (22) ausgebildet ist, um ein erstes Frequenzfenster (46; 46a) auf die erste Version (14) des Spektrogramms anzuwenden und um die zweite Version (24) des Spektrogramms basierend auf Frequenzanteilen (45), für die das erste Frequenzfenster (46; 46a) einen Funktionsbetragswert aufweist, der größer als ein Schwellwert ($X_1[n]$) ist, zu erhalten.

7. Vorrichtung gemäß Anspruch 6, bei der der Prozessor (22) ausgebildet ist, um zumindest ein zweites Frequenzfenster (46b) auf die erste Version (14) des Spektrogramms anzuwenden und um die zweite Version (24) des Spektrogramms basierend auf Frequenzanteilen (45), für die das erste (46; 46a) und das zumindest zweite Frequenzfenster (46b) ein Ergebnis liefern, das größer als der Schwellwert ($X1[n]$) ist, zu erhalten, wobei das erste Frequenzfenster (46; 46a) und das zumindest zweite Frequenzfenster (46b) eine zueinander verschobene Gruppenlaufzeit aufweisen.

8. Vorrichtung gemäß einem der vorangehenden Ansprüche, umfassend:

   einen Signaleingang (38), der ausgebildet ist, um ein Eingangssignal (44) zu empfangen, das eine Vorgabe bezüglich einer Abtastrate aufweist,
   einem Steuerelement (42), das ausgebildet ist, um den Vorwärtstransformator (12) zu steuern, so dass eine Länge der ersten Transformationslänge (N1) verändert wird, oder um den Prozessor (22) zu steuern, so dass eine Länge der zweiten Transformationslänge (N3) verändert wird.

9. Vorrichtung gemäß Anspruch 8, bei der sich die Vorgabe auf die dritte Abtastrate ($1/T_2$) bezieht und bei der das Steuerelement (42) ausgebildet ist, um die dritte Abtastrate ($1/T_2$) des Zeitbereichsinterpolators (32) einzustellen.

10. Vorrichtung gemäß Anspruch 8 oder 9, bei der sich die Vorgabe auf die dritte Abtastrate ($1/T_2$) bezieht und bei das Steuerelement (42) ausgebildet ist, um einen Frequenzbereich eines Frequenzfensters (46; 46a, 46b) zu steuern, wobei die Bandbreite der zweiten Version (24) des Spektrogramms von dem Frequenzbereich des Frequenzfensters (46; 46a, 46b) beeinflusst ist.

11. Vorrichtung gemäß einem der Ansprüche 6 bis 10, bei der die zweite Version (24) des Spektrogramms mit einer ersten Anzahl (N2) von Frequenzlinien (45) darstellbar ist, wobei der Prozessor (22) ausgebildet ist, um der ersten Anzahl (N2) eine zweite Anzahl von Frequenzlinien (48) mit einem vordefinierten Wert hinzuzufügen, wobei eine Summe der ersten Anzahl (N2) und der zweiten Anzahl der kleinsten Potenz der Zahl zwei mit einer natürlichen Zahl entspricht, die größer als oder gleich der ersten Anzahl (N2) ist.

12. Vorrichtung gemäß Anspruch 11, bei der der Prozessor (22) ausgebildet ist, um der ersten Anzahl (N2) von Frequenzlinien (45) eine dritte Anzahl von Frequenzlinien (48) mit dem vordefinierten Wert hinzuzufügen, wobei die dritte Anzahl der einfachen oder der dreifachen Anzahl der ersten (N2) und der zweiten Anzahl entspricht.

13. Verfahren (300) zum Verändern einer Abtastrate mit folgenden Schritten:

   Bilden (310) einer ersten Version (14) eines Spektrogramms in einer Frequenzbereichsdarstellung mittels einer Fourier-Transformation mit einer ersten Transformationslänge (N1) aus einem in einer Zeitbereichsdarstellung erhaltenem Informationssignal (16) das eine erste Abtastrate ($1/T_1$) aufweist;
   Bilden (320) einer zweiten Version (24) des Spektrogramms aus der ersten Version vermittels einer Bandbegrenzung, die gegenüber der ersten Version (14) eine geringere Bandbreite aufweist, so dass die zweite Version (24) des Spektrogramms mit einer ersten Anzahl (N2) von Frequenzlinien (45) darstellbar ist;
   Hinzufügen einer zweiten Anzahl von Frequenzlinien (48) mit einem vordefinierten Wert zu der ersten Anzahl (N2), so dass eine Summe der ersten Anzahl (N2) und der zweiten Anzahl der kleinsten Potenz der Zahl zwei mit einer natürlichen Zahl entspricht, die größer als oder gleich der ersten Anzahl (N2) ist;
   Bilden (330) eines grob vorveränderten Informationssignals (28) mit einer zweiten Abtastrate, die gegenüber der ersten Abtastrate ($1/T1$) verändert ist, mittels einer Rücktransformation durch eine inverse Fourier-Transformation der zweiten Version (24) mit einer zweiten Transformationslänge (N3), die der Summe entspricht und die gegenüber der ersten Transformationslänge (N1) verändert ist; und
   Erhalten (340) eines Informationssignals (34) mit einer dritten Abtastrate ($1/T_2$), die gegenüber der zweiten Abtastrate verändert ist, mittels Interpolation des vorveränderten Informationssignals (28).

14. Verfahren (300) zum Verändern einer Abtastrate mit folgenden Schritten:

   Bilden (310) einer ersten Version (14) eines Spektrogramms in einer Frequenzbereichsdarstellung mittels einer Fourier-Transformation mit einer ersten Transformationslänge (N1) aus einem in einer Zeitbereichsdarstellung erhaltenem Informationssignal (16) das eine erste Abtastrate ($1/T_1$) aufweist;

Bilden (320) einer zweiten Version (24) des Spektrogramms vermittels einer Bandbegrenzung, die gegenüber der ersten Version (14) eine geringere Bandbreite aufweist;

Bilden (330) eines grob vorveränderten Informationssignals (28) mit einer zweiten Abtastrate, die gegenüber der ersten Abtastrate ($1/T_1$) verändert ist, mittels einer Rücktransformation durch eine inverse Fourier-Transformation der zweiten Version (24) mit einer zweiten Transformationslänge (N3), die gegenüber der ersten Transformationslänge (N1) verändert ist; und

Erhalten (340) eines Informationssignals (34) mit einer dritten Abtastrate ($1/T_2$), die gegenüber der zweiten Abtastrate verändert ist, mittels Interpolation des vorveränderten Informationssignals (28);

Anwenden eines ersten Frequenzfensters (46; 46a) auf die erste Version (14) des Spektrogramms und Erhalten der zweiten Version (24) des Spektrogramms basierend auf Frequenzanteilen (45), für die das erste Frequenzfenster (46; 46a) einen Funktionsbetragswert aufweist, der größer als ein Schwellwert ($X_1[n]$) ist.

15. Computerprogramm mit einem Programmcode zur Durchführung des Verfahrens nach Anspruch 13 oder 14, wenn das Programm auf einem Computer läuft.


**Claims**

1. Apparatus for modifying a sampling rate, comprising:

   a forward transformer (12) for forming a first version (14) of a spectrogram in a frequency domain representation by means of a Fourier transformation with a first transformation length (N1) from an information signal (16) obtained in a time domain representation and having a first sampling rate ($1/T_1$);
   a processor (22) for forming, from the first version by means of a band limitation, a second version (24) of the spectrogram comprising a bandwidth that is lower with respect to the first version (14);
   wherein the second version (24) of the spectrogram can be represented with a first quantity (N2) of frequency lines (45), wherein the processor (22) is configured to add a second quantity of frequency lines (48) with a predefined value to the first quantity (N2), wherein a sum of the first quantity (N2) and the second quantity corresponds to the smallest power of two with a natural number that is greater than or equal to the first quantity (N2)
   a reverse transformer (26) for forming a coarsely pre-modified information signal (28) with a second sampling rate that is modified with respect to the first sampling rate ($1/T_1$), by means of reverse transformation by an inverse Fourier transformation of the second version (24) of the spectrogram with a second transformation length (N3) corresponding to the sum and being modified with respect to the first transformation length (N1); and
   a time domain interpolator (32) for acquiring an information signal (34) with a third sampling rate ($1/T_2$) that is modified with respect to the second sampling rate, by means of interpolation of the pre-modified information signal (28).

2. Apparatus according to claim 1, wherein the time domain interpolator (32) is configured to interpolate the information signal (34) with the third sampling rate ($1/T_2$) such that a difference between the first sampling rate and the third sampling rate ($1/T_2$) is lower than a difference between the second sampling rate and the third ($1/T_1$) sampling rate, wherein the information signal (34) with the third sampling rate is a finely modified information signal.

3. Apparatus according to claim 1 or 2, wherein the time domain interpolator (32) is configured to interpolate the information signal (34) with the third sampling rate ($1/T_2$) such that the third sampling rate ($1/T_2$) is reduced with respect to the second sampling rate.

4. Apparatus according any of the preceding claims, wherein the time domain interpolator (32) is configured to acquire sampling values (54) of the third sampling rate ($1/T_2$) by means of polynomial interpolation, wherein the polynomial interpolation is based on sampling values (52a, 52b) of the second sampling rate.

5. Apparatus according to claim 4, wherein the time domain interpolator (32) is configured to acquire a sampling value (54) of the third sampling rate ($1/T_2$) based on at least two and at the most eight sampling values (52a, 52b) of the second sampling rate or to perform the polynomial interpolation with a degree, wherein the degree comprises a value of at least 1 and at the most 7.

6. Apparatus for modifying a sampling rate, comprising:

   a forward transformer (12) for forming a first version (14) of a spectrogram by means of a Fourier transformation with a first transformation length (N1) from an information signal (16) obtained in a time domain representation and having a first sampling rate ($1/T_1$);

a processor (22) for forming, by means of a band limitation, a second version (24) of the spectrogram comprising a bandwidth that is lower with respect to the first version (14);

a reverse transformer (26) for forming a coarsely pre-modified information signal (28) with a second sampling rate that is modified with respect to the first sampling rate ($1/T_1$), by means of reverse transformation by an inverse Fourier transformation of the second version (24) of the spectrogram with a second transformation length (N3) that is modified with respect to the first transformation length (N1); and

a time domain interpolator (32) for acquiring an information signal (34) with a third sampling rate ($1/T_2$) that is modified with respect to the second sampling rate, by means of interpolation of the pre-modified information signal (28);

wherein the processor (22) is configured to apply a first frequency window (46; 46a) to the first version (14) of the spectrogram and to acquire the second version (24) of the spectrogram based on frequency portions (45) for which the first frequency window (46; 46a) comprises an absolute value of the function that is greater than a threshold ($X_1[n]$).

7. Apparatus according to claim 6, wherein the processor (22) is configured to apply at least a second frequency window (46b) to the first version (14) of the spectrogram and to acquire the second version (24) of the spectrogram based on frequency portions (45) for which the first (46; 46a) and the at least second (46b) frequency window provide a result that is greater than the threshold ($X_1[n]$), wherein the first frequency window (46; 46a) and the at least second frequency window (46b) comprise group runtimes that are shifted with respect to one another.

8. Apparatus according to any of the preceding claims, comprising:

a signal input (38) that is configured to receive an input signal (44) comprising a set value with respect to a sampling rate,

a control element (42) that is configured to control the forward transformer (12) such that a length of the first transformation length (N1) is modified or to control the processor (22) such that a length of the second transformation length (N3) is modified.

9. Apparatus according to claim 8, wherein the set value relates to the third sampling rate ($1/T_2$) and wherein the control element (42) is configured to adjust the third sampling rate ($1/T_2$) of the time domain interpolator (32).

10. Apparatus according to claim 8 or 9, wherein the set value relates to the third sampling rate ($1/T_2$) and wherein the control element (42) is configured to control a frequency domain of a frequency window (46; 46a, 46b), wherein the bandwidth of the second version (24) of the spectrogram is influenced by the frequency domain of the frequency window (46; 46a, 46b).

11. Apparatus according to any of claims 6 to 10, wherein the second version (24) of the spectrogram can be represented with a first quantity (N2) of frequency lines (45), wherein the processor (22) is configured to add a second quantity of frequency lines (48) with a predefined value to the first quantity (N2), wherein a sum of the first quantity (N2) and the second quantity corresponds to the smallest power of two with a natural number that is greater than or equal to the first quantity (N2).

12. Apparatus according to claim 11, wherein the processor (22) is configured to add a third quantity of frequency lines (48) with a predefined value to the first quantity (N2) of frequency lines (45), wherein the third quantity corresponds to one or three times the first (N2) and the second quantity.

13. Method (300) for modifying a sampling rate, comprising:

forming (310) a first version (14) of a spectrogram in a frequency domain representation by means of a Fourier transformation with a first transformation length (N1) from an information signal (16) obtained in a time domain representation and having a first sampling rate ($1/T_1$);

forming (320), from the first version by means of a band limitation, a second version (24) of the spectrogram comprising a bandwidth that is lower with respect to the first version (14) so that the second version (24) of the spectrogram can be represented with a first quantity (N2) of frequency lines (45);

adding a second quantity of frequency lines (48) with a predefined value to the first quantity (N2) so that a sum of the first quantity (N2) and the second quantity corresponds to the smallest power of two with a natural number that is greater than or equal to the first quantity (N2);

forming (330) a coarsely pre-modified information signal (28) with a second sampling rate that is modified with respect to the first sampling rate ($1/T_1$), by means of reverse transformation by inverse Fourier transformation of the second version (24) with a second transformation length (N3) corresponding to the sum and being modified with respect to the first transformation length (N1); and

acquiring (340) an information signal (34) with a third sampling rate ($1/T_2$) that is modified with respect to the second sampling rate, by means of interpolation of the pre-modified information signal (28).

14. Method (300) for modifying a sampling rate, comprising:

forming (310) a first version (14) of a spectrogram in a frequency domain representation by means of a Fourier transformation with a first transformation length (N1) from an information signal (16) obtained in a time domain representation and having a first sampling rate ($1/T_1$);
forming (320), by means of a band limitation, a second version (24) of the spectrogram comprising a bandwidth that is lower with respect to the first version (14);
forming (330) a coarsely pre-modified information signal (28) with a second sampling rate that is modified with respect to the first sampling rate ($1/T_1$), by means of reverse transformation by an inverse Fourier transformation of the second version (24) with a second transformation length (N3) that is modified with respect to the first transformation length (N1); and
acquiring (340) an information signal (34) with a third sampling rate ($1/T_2$) that is modified with respect to the second sampling rate, by means of interpolation of the pre-modified information signal (28);
applying a first frequency window (46; 46a) to the first version (14) of the spectrogram and acquiring the second version (24) of the spectrogram based on frequency portions (45) for which the first frequency window (46; 46a) comprises an absolute value of the function that is greater than a threshold ($X_1[n]$).

15. Computer program having a program code for performing the method according to claim 13 or 14 when the method runs on a computer.

**Revendications**

1. Dispositif pour modifier une fréquence de balayage, avec:

un transformateur direct (12) destiné à former une première version (14) d'un spectrogramme dans une représentation dans le domaine de la fréquence au moyen d'une transformée de Fourier d'une première longueur de transformation (N1) à partir d'un signal d'information (16) obtenu dans une représentation dans le domaine temporel qui présente une première fréquence de balayage ($1/T_1$);
un processeur (22) destiné à former une deuxième version (24) du spectrogramme à partir de la première version à l'aide d'une limitation de bande qui présente, par rapport à la première version (14), une largeur de bande plus réduite;
dans lequel la deuxième version (24) du spectrogramme peut être représentée avec un premier nombre (N2) de lignes de fréquence (45), dans lequel le processeur (22) est conçu pour ajouter au premier nombre (N2) un deuxième nombre de lignes de fréquence (48) avec une valeur prédéfinie, dans lequel une somme du premier nombre (N2) et du deuxième nombre correspond à la puissance la plus petite du nombre deux avec un nombre entier naturel qui est supérieur ou égal au premier nombre (N2);
un transformateur inverse (26) destiné à former un signal d'information grossièrement pré-modifié (28) avec une deuxième fréquence de balayage, qui est modifiée par rapport à la première fréquence de balayage (1/Ti), au moyen d'une transformation inverse par une transformée de Fourier inverse de la deuxième version (24) du spectrogramme d'une deuxième longueur de transformation (N3) qui correspond à la somme et qui est modifiée par rapport à la première longueur de transformation (N1); et
un interpolateur dans le domaine temporel (32) destiné à obtenir un signal d'information (34) avec une troisième fréquence de balayage ($1/T_2$) qui est modifiée par rapport à la deuxième fréquence de balayage au moyen d'une interpolation du signal d'information pré-modifié (28).

2. Dispositif selon la revendication 1, dans lequel l'interpolateur dans le domaine temporel (32) est conçu pour interpoler le signal d'information (34) avec la troisième fréquence de balayage ($1/T_2$) de sorte qu'une différence entre la première fréquence de balayage et la troisième fréquence de balayage ($1/T_2$) soit inférieure à une différence entre la deuxième fréquence de balayage et la troisième fréquence de balayage (1/Ti), dans lequel le signal d'information (34) avec la troisième fréquence de balayage est un signal d'information finement modifié.

3. Dispositif selon la revendication 1 ou 2, dans lequel l'interpolateur dans le domaine temporel (32) est conçu pour interpoler le signal d'information (34) avec la troisième fréquence de balayage ($1/T_2$) de sorte que la troisième fréquence de balayage ($1/T_2$) soit réduite par rapport à la deuxième fréquence de balayage,

**4.** Dispositif selon l'une des revendications précédentes, dans lequel l'interpolateur dans le domaine temporel (32) est conçu pour obtenir des valeurs de balayage (54) de la troisième fréquence de balayage $(1/T_2)$ au moyen d'une interpolation polynomiale, dans lequel l'interpolation polynomiale est basée sur des valeurs de balayage (52a, 52b) de la deuxième fréquence de balayage.

**5.** Dispositif selon la revendication 4, dans lequel l'interpolateur dans le domaine temporel (32) est conçu pour obtenir une valeur de balayage (54) de la troisième fréquence de balayage $(1/T_2)$ sur base d'au moins deux et de tout au plus huit valeurs de balayage (52a, 52b) de la deuxième fréquence de balayage ou pour effectuer l'interpolation polynomiale à un degré, dans lequel le degré présente une valeur d'au moins 1 et de tout au plus 7.

**6.** Dispositif pour modifier une fréquence de balayage, avec:

un transformateur direct (12) destiné à former une première version (14) d'un spectrogramme au moyen d'une transformée de Fourier d'une première longueur de transformation (N1) à partir d'un signal d'information (16) obtenu dans une représentation dans le domaine temporel qui présente une première fréquence de balayage $(1/Ti)$;
un processeur (22) destiné à former une deuxième version (24) du spectrogramme à l'aide d'une limite de bande qui présente, par rapport à la première version (14), une largeur de bande plus réduite;
un transformateur inverse (26) destiné à former un signal d'information grossièrement pré-modifié (28) avec une deuxième fréquence de balayage, qui est modifiée par rapport à la première fréquence de balayage $(1/T_1)$, au moyen d'une transformation inverse par une transformée de Fourier inverse de la deuxième version (24) du spectrogramme d'une deuxième longueur de transformation (N3) qui est modifiée par rapport à la première longueur de transformation (N1); et
un interpolateur dans le domaine temporel (32) destiné à obtenir un signal d'information (34) avec une troisième fréquence de balayage $(1/T_2)$ qui est modifiée par rapport à la deuxième fréquence de balayage au moyen d'une interpolation du signal d'information pré-modifié (28),
dans lequel le processeur (22) est conçu pour appliquer une première fenêtre de fréquence (46; 46a) à la première version (14) du spectrogramme et pour obtenir la deuxième version (24) du spectrogramme sur base de parts de fréquence (45) pour lesquelles la première fenêtre de fréquence (46; 46a) présente une valeur de quantité de fonction qui est supérieure à un seuil $(X_1[n])$.

**7.** Dispositif selon la revendication 6, dans lequel le processeur (22) est conçu pour appliquer au moins une deuxième fenêtre de fréquence (46b) à la première version (14) du spectrogramme et pour obtenir la deuxième version (24) du spectrogramme sur base des parts de fréquence (45) pour lesquelles la première (46; 46a) et l'au moins deuxième fenêtre de fréquence (46b) fournissent un résultat qui est supérieur à la valeur de seuil (X1[n]), dans lequel la première fenêtre de fréquence (46; 46a) et l'au moins deuxième fenêtre de fréquence (46b) présentent une durée de fonctionnement de groupe décalée entre elles.

**8.** Dispositif selon l'une des revendications précédentes, comprenant:

une entrée de signal (38) qui est conçue pour recevoir un signal d'entrée (44) qui présente une spécification relative à une fréquence de balayage,
un élément de commande (42) qui est conçu pour commander le transformateur direct (12) de sorte que soit modifiée une longueur de la première longueur de transformation (N1), ou pour commander le processeur (22) de sorte que soit modifiée une longueur de la deuxième longueur de transformation (N3),

**9.** Dispositif selon la revendication 8, dans lequel la spécification se rapporte à la troisième fréquence de balayage $(1/T_2)$ et dans lequel l'élément de commande (42) est conçu pour régler la troisième fréquence de balayage $(1/T_2)$ de l'interpolateur dans le domaine temporel (32).

**10.** Dispositif selon la revendication 8 ou 9, dans lequel la spécification se rapporte à la troisième fréquence de balayage $(1/T_2)$ et dans lequel l'élément de commande (42) est conçu pour commander une plage de fréquences d'une fenêtre de fréquence (46; 46a, 46b), dans lequel la largeur de bande de la deuxième version (24) du spectrogramme est influencée par la plage de fréquences de la fenêtre de fréquence (46; 46a, 46b).

**11.** Dispositif selon l'une des revendications 6 à 10, dans lequel la deuxième version (24) du spectrogramme peut être représentée avec un premier nombre (N2) de lignes de fréquence (45), dans lequel le processeur (22) est conçu pour ajouter au premier nombre (N2) un deuxième nombre de lignes de fréquence (48) d'une valeur prédéfinie, où une somme du premier nombre (N2) et du deuxième nombre correspond à la puissance la plus petite du nombre deux avec un nombre entier naturel qui est supérieur ou égal au premier nombre (N2).

12. Dispositif selon la revendication 11, dans lequel le processeur (22) est conçu pour ajouter au premier nombre (N2) de lignes de fréquence (45) un troisième nombre de lignes de fréquence (48) à la valeur prédéfinie, où le troisième nombre correspond au nombre simple ou triple du premier (N2) et du deuxième nombre.

13. Procédé (300) pour changer une fréquence de balayage, aux étapes suivantes consistant à :

former (310) une première version (14) d'un spectrogramme dans une représentation dans le domaine de la fréquence au moyen d'une transformée de Fourier d'une première longueur de transformée (N1) à partir d'un signal d'information (16) obtenu dans une représentation dans le domaine temporel qui présente une première fréquence de balayage (1/$T_1$);
former (320) une deuxième version (24) du spectrogramme à partir de la première version au moyen d'une limitation de bande, qui présente, par rapport à la première version (14), une largeur de bande plus réduite, de sorte que la deuxième version (24) du spectrogramme puisse être représentée avec un premier nombre (N2) de lignes de fréquence (45);
ajouter un deuxième nombre de lignes de fréquence (48) d'une valeur prédéfinie au premier nombre (N2), de sorte qu'une somme du premier nombre (N2) et du deuxième nombre corresponde à la puissance la plus petite du nombre deux avec un nombre naturel qui est supérieur ou égal au premier nombre (N2);
former (330) un signal d'information grossièrement pré-modifié (28) avec une deuxième fréquence de balayage, qui est modifiée par rapport à la première fréquence de balayage (1/$T_1$), au moyen d'une transformation inverse par une transformée de Fourier inverse de la deuxième version (24) d'une deuxième longueur de transformation (N3) qui correspond à la somme et qui est modifiée par rapport à la première longueur de transformation (N1); et
obtenir (340) un signal d'information (34) avec une troisième fréquence de balayage (1/$T_2$), qui est modifiée par rapport à la deuxième fréquence de balayage, au moyen d'une interpolation du signal d'information pré-modifié (28).

14. Procédé (300) pour changer une fréquence de balayage, aux étapes suivantes consistant à :

former (310) une première version (14) d'un spectrogramme dans une représentation dans le domaine de la fréquence au moyen d'une transformée de Fourier d'une première longueur de transformation (N1) à partir d'un signal d'information (16) obtenu dans une représentation dans le domaine temporel qui présente une première fréquence de balayage (1/$T_1$);
former (320) une deuxième version (24) du spectrogramme au moyen d'une limitation de bande qui présente, par rapport à la première version (14), une largeur de bande plus réduite;
former (330) un signal d'information grossièrement pré-modifié (28) avec un deuxième fréquence de balayage, qui est modifiée par rapport à la première fréquence de balayage (1/$T_1$), au moyen d'une transformation inverse par une transformée de Fourier inverse de la deuxième version (24) d'une deuxième longueur de transformation (N3) qui est modifiée par rapport à la première longueur de transformation (N1); et
obtenir (340) un signal d'information (34) avec une troisième fréquence de balayage (1/$T_2$), qui est modifiée par rapport à la deuxième fréquence de balayage, par une interpolation du signal d'information pré-modifié (28);
appliquer une première fenêtre de fréquence (46; 46a) à la première version (14) du spectrogramme et obtenir la deuxième version (24) du spectrogramme sur base de parts de fréquence (45) pour lesquelles la première fenêtre de fréquence (46; 46a) présente une valeur de quantité de fonction qui est supérieure à un seuil (Xi[n]).

15. Programme d'ordinateur avec un code de programme pour la mise en oeuvre du procédé selon la revendication 13 ou 14 lorsque le programme est exécuté sur un ordinateur.

FIGUR 1

FIGUR 2

300

| Bilden einer ersten Version eines Spektrogramms mittels einer Transformation mit einer ersten Transformationslänge aus einem Informationssignal, das eine erste Abtastrate aufweist | 310 |

| Bilden einer zweiten Version des Spektrogramms, die gegenüber der ersten Version eine veränderte Bandbreite aufweist | 320 |

| Bilden eines grob vorveränderten Informationssignals mit einer zweiten Abtastrate, die gegenüber der ersten Abtastrate verändert ist, mittels einer Rücktransformation der zweiten Version mit einer zweiten Transformationslänge, die gegenüber der ersten Transformationslänge verändert ist | 330 |

| Erhalten eines Informationssignals mit einer dritten Abtastrate mittels Interpolation des vorveränderten Informationssignals, wobei die dritte Abtastrate gegenüber der zweiten Abtastrate verändert ist | 340 |

## FIGUR 3

x(t)

16

FIGUR 4A    T₁    t

EP 3 332 478 B1

X[n]    FFT(N1)

14

45

FIGUR 4B    n

FIGUR 4C

FIGUR 4D

EP 3 332 478 B1

FIGUR 4E

FIGUR 4F

FIGUR 5A

FIGUR 5B

FIGUR 5C

EP 3 332 478 B1

FIGUR 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **A TKACENKO.** *Variable Sample Rate Conversion Techniques for the Advanced Receiver,* 15. Februar 2007, https:// ipn-pr.jpl.nasa.gov/progress_report/42-168/168A.pdf